(19)

Europäisches
Patentamt
European
Patent Office
Office européen
des brevets

(11) **EP 2 196 838 A1**

(12) **EUROPEAN PATENT APPLICATION**

(43) Date of publication:
**16.06.2010 Bulletin 2010/24**

(51) Int Cl.:
*G02B 17/08* (2006.01)    *G03F 7/20* (2006.01)

(21) Application number: **08021519.7**

(22) Date of filing: **11.12.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(71) Applicant: **Carl Zeiss SMT AG
73447 Oberkochen (DE)**

(72) Inventor: **Epple, Alexander Dr.
73431 Aalen (DE)**

(74) Representative: **Patentanwälte
Ruff, Wilhelm, Beier, Dauster & Partner
Kronenstraße 30
D-70174 Stuttgart (DE)**

(54) **Chromatically corrected catadioptric objective and projection exposure apparatus including the same**

(57)    A catadioptric objective (300) comprises a plurality of optical elements arranged along a single straight optical axis (OA) to image a pattern from an off-axis object field (OS) to an off-axis image field (IS). The optical elements include a concave mirror (CM1,CM2) and a plurality of lenses made from different crown and flint materials. The lenses include two negative lenses (L1-6,L1-8,L3-3,L3-9) made of flint material (eg. LF5), having relatively high dispersion. One of the negative lenses is arranged in a region of relatively small marginal ray height where the marginal ray height is less than 70% of the maximum marginal ray height in the objective, and another negative lens is arranged in a region of relatively high marginal ray height where the marginal ray height is at least 70% of the maximum marginal ray height in the objective.

Fig. 3A

Printed by Jouve, 75001 PARIS (FR)

**Description**

BACKGROUND OF THE INVENTION

Field of the Invention

The invention relates to a catadioptric objective. The objective may be configured as catadioptric projection objective which may be used in a microlithographic projection exposure apparatus to expose a radiation-sensitive substrate arranged in the region of an image surface of the projection objective with at least one image of pattern of a mask that is arranged in the region of an object surface of the projection objective. The invention also relates to a projection exposure apparatus which includes such catadioptric objective.

Description of the Related Art

Microlithographic projection exposure methods and apparatus are used to fabricate semiconductor components and other finely patterned components. A microlithographic exposure process involves using a mask (reticle) that carries or forms a pattern of a structure to be imaged, for example a line pattern of a layer of a semiconductor component. The pattern is positioned in a projection exposure apparatus between an illumination system and a projection objective in a region of the object surface of the projection objective. Primary radiation from the ultraviolet electromagnetic spectrum (UV radiation) is provided by a primary radiation source and transformed by optical components of the illumination system to produce illumination radiation directed at the pattern of the mask. The radiation modified by the mask and the pattern passes through the projection objective, which forms an image of the pattern in the image surface of the projection objective, where a substrate to be exposed is arranged. The substrate, e.g. a semiconductor wafer, normally carries a radiation-sensitive layer (photoresist).

Purely refractive projection objectives have been predominantly used for optical lithography in the past. However, correction of elementary aberrations, such as correction of chromatic aberrations and correction for the Petzval sum (image field curvature) become more difficult as NA is increased and shorter wavelengths are used.

One approach for obtaining a flat image surface and good correction of chromatic aberrations is the use of catadioptric optical systems, which combine both refracting elements, such as lenses, and reflecting elements with optical power, such as at least one concave mirror. While the contributions of positive-powered and negative-powered lenses in an optical system to overall power, image field curvature and chromatic aberrations are opposite to each other, a concave mirror has positive power like a positive-powered lens, but the opposite effect on image field curvature without contributing to chromatic aberrations.

A concave mirror is difficult to integrate into an optical system, since it sends the radiation right back in the direction it came from. Configurations integrating a concave mirror without causing problems due to beam vignetting and pupil obscuration are desirable.

Various types of primary radiation sources are currently used in the field of microlithography. In some cases, a laser is used as primary radiation source. A natural bandwidth of the laser may be narrowed by appropriate bandwidth narrowing devices. For example, a natural bandwidth of about $\Delta\lambda=500$ pm may be reduced by three orders of magnitude to obtain radiation having a bandwidth $\Delta\lambda \approx 0.5$ pm used for the exposure. Where radiation with a relatively small bandwidth is used for the exposure, chromatic aberrations caused by the optical elements of the projection objective may be kept relatively small without specific efforts for chromatic correction (correction of chromatic aberrations).

The situation is different in microlithographic systems having primary radiation source emitting ultraviolet radiation from a relatively broad wavelength band. For example, a mercury vapour lamp or a light emitting diode (LED) may be used as primary radiation source. Specifically, projection exposure systems having a central wavelength $\lambda= 365.5$ nm $\pm$ 2nm (so-called i-line system) have been in use for a long time. Those systems utilize the i-line of a mercury vapour lamp, the natural bandwidth thereof being limited to a narrower utilized band width $\Delta\lambda$ of about 2nm with the aid of filters or in some other way. Other spectral lines of a mercury vapour lamp may also be used for exposure, such as the mercury h-line at about 405nm and the mercury g-line at about 436nm. The electromagnetic spectrum of each of the lines is relatively broad, thereby requiring that the projection objective should provide a relatively efficient correction of chromatic aberrations in order to ensure low-aberration imaging even with such broad band radiation at the required resolution. Chromatic correction is also required if it is desired to use a laser source at the natural line width or a laser source having only moderate line width narrowing.

Chromatic aberrations occur basically because of the fact that the index of refraction, n, of transparent optical materials varies as a function of the wavelength $\lambda$. In general, the index of refraction of optical materials is higher for shorter wavelength than for longer wavelength. Chromatic aberrations may be subdivided into different categories. A first category of chromatic aberrations includes deviations of position, shape and/or size of images formed at different wavelength from an ideal image. This accounts for the fact that a paraxial image is formed for each wavelength, and the images usually differ in position, shape and/or size. The chromatic aberrations of the first category are usually referred to as "axial chromatic aberration" (or axial color, AX) and "chromatic difference of magnification" (or lateral color, LAT).

Axial chromatic aberration is the longitudinal variation of paraxial focus (or image position) with wavelength. Where the index of refraction of an optical material is higher for shorter wavelength than for longer wavelength, the short wavelengths are more strongly refracted at each surface of a lens element so that, in a simple positive lens, for example, the relatively shorter wavelength rays are brought to a focus closer to the lens than the relatively longer wavelength rays. The paraxial distance along the optical axis of the lens between the two focus points is the axial chromatic aberration. When the shorter wavelength rays are brought to focus closer to the positive lens than the longer wavelength rays, the longitudinal axial chromatic aberration is usually termed "undercorrected" or "negative".

When a lens system forms images of different sizes for different wavelengths or spreads the image of an off-axis point into a color fringe, the difference between the paraxial image heights for different colors is usually denoted lateral color or chromatic difference of magnification.

The chromatic variation of the index of refraction also produces a variation of monochromatic aberrations, which may be summarized in a second category of chromatic aberrations. The variation of monochromatic aberrations include the chromatic variation of spherical aberration, the chromatic variation of coma, the chromatic variation of astigmatism, the chromatic variation of distortion and the chromatic variation of image field curvature.

In some cases, blurred images with low contrast particularly near the outer edges of extended image fields have been observed in objectives used with relatively broadband radiation sources.

Applicant's European Patent application EP 1 855 160 A2 (corresponding to US Serial Number 11/747630) discloses catadioptric reduction projection objectives for broadband application. The projection objectives are configured to image the structure of a mask onto a light-sensitive substrate by means of projection light from a wavelength band having a bandwidth $\Delta\lambda > 10$ pm around a central operating wavelength $\lambda > 200$ nm with an image-side numerical aperture NA > 0.6. The projection objectives contain a concave mirror arranged in a region of a pupil surface of the projection objective, and a negative group having at least one negative lens arranged in direct proximity to the concave mirror in a region near the pupil surface, where a marginal ray height of the imaging is greater than a chief ray height. A negative group in the region of relatively large marginal ray heights can contribute effectively to the chromatic correction, in particular to the correction of the axial chromatic aberration AX, since the axial chromatic aberration AX of a thin lens is proportional to the square of the marginal ray height at the location of the lens (and proportional to the refractive power and to the dispersion of the lens). Added to this is the fact that the projection radiation passes twice, in opposite through-radiating directions, through a negative group arranged in direct proximity to a concave mirror, with the result that the chromatically overcorrecting effect of the negative group is utilized twice. The combination of a concave mirror arranged near or at the pupil with a negative group arranged directly in front of the mirror surface is sometimes denoted as a "Schupmann achromat" (cf. US 620,978). No special means are presented to correct chromatic variation of the Petzval sum.

US 4,469,414 shows restricted Dyson-like off-axis catadioptric optical systems with corrected Petzval sum, which can be used with a broad spectral range.

SUMMARY OF THE INVENTION

It is one object of the invention to provide an objective useful for microlithography which may be operated with ultraviolet radiation provided by a broadband radiation source.

It is another object of the invention to provide an objective useful for microlithography which generates an image with sufficient contrast over the entire image field when operated with ultraviolet radiation provided by a broadband radiation source.

It is another object of the invention to provide an objective having a good correction status with respect to chromatic variation of the Petzval sum.

It is another object of the invention to provide a mechanically stable objective for broadband applications, which has good polarization performance.

To address these and other objects the invention, according to one formulation of the invention, provides a catadioptric objective comprising:

a plurality of optical elements arranged along a single straight optical axis to image a pattern from an off-axis object field in an object surface of the objective to an off-axis image field arranged in an image surface region of the objective at an image-side numerical aperture NA with electromagnetic radiation from a wavelength band around a central wavelength $\lambda$, the optical elements including at least one concave mirror and a plurality of lenses;

wherein the plurality of lenses include lenses made from different materials having different Abbe numbers defining a median Abbe number, wherein at least one of the plurality of lenses is a first lens made from a first material having a first Abbe number equal to or greater than the median Abbe number and at least one of the plurality of lenses is made from a second material having an Abbe number smaller than the median Abbe number;

wherein the lenses include at least two negative lenses of a second material,

wherein at least one of the negative lenses is a first negative lens arranged in a region of relatively small marginal ray height where a marginal ray height is less than 70% of a maximum marginal ray height in the objective,

and at least one of the negative lenses is a second negative lens arranged in a region of relatively high marginal ray height where a marginal ray height is at least 70% of a maximum marginal ray height in the objective.

Folded systems may be properly designed to have a convave mirror in a pupil surface, thereby allowing to provide a Schupmann achromat as a powerful means for chromatic correction. However, there are practical drawbacks with regard to polarization control, mechanical complexity and stability, and image flip. The polarization state of the projection beam may be influenced by reflections at reflecting surfaces inclined to the optical axis. As the optical axis is folded into different sections inclined relative to each other, a -multi-barrel-design for the mounting structure must typically be used, requiring mechanically complex constructions. Depending on the overall number of reflections within the projection objective, the magnification ratio may have the same amount, but different sign in mutually perpendicular directions in the image plane, which problem is also denoted as "image flip".

These problems may be avoided if the catadioptric projection objective is designed as an "in-line system", i.e. as a catadioptric projection objective having one straight (unfolded) optical axis common to all optical elements of the projection objective. From an optical point of view, in-line systems may be favorable since optical problems caused by utilizing planar folding mirrors, such as polarization effects, can be avoided. Also, from a manufacturing point of view, in-line systems may be designed such that conventional mounting techniques for optical elements can be utilized, thereby improving mechanical stability of the projection objectives. Utilizing an even number of mirrors, such as two or four or six mirrors, allows to avoid image flip.

At least two different transparent optical materials are used for the lenses to support chromatic correction, particularly correction of axial chromatic aberration, lateral chromatic aberration, and chromatic variation of Petzval curvature. In those systems the plurality of lenses includes lenses made from different materials having different Abbe numbers. The Abbe number $\nu$ for a material having a refractive index n (dependent on the wavelength $\lambda$) may be generally defined as follows:

$$\nu = \frac{n-1}{n_{\lambda 1} - n_{\lambda 2}}, \qquad\qquad (A1)$$

where $\lambda_1$ and $\lambda_2 > \lambda_1$ are different wavelengths that determine the bandwidth for the calculation of the Abbe number, n is the index of refraction at a wavelength $\lambda$ between $\lambda_2$ and $\lambda_1$ and $n_{\lambda 1}$, $n_{\lambda 2}$ are the refractive indices for $\lambda_1$ and $\lambda_2$, respectivly. The Abbe number is sometimes referred to as "reciprocal relative dispersion" indicating that, in general, relatively high Abbe numbers correspond to materials having relatively low dispersion and vice versa, where the dispersion of a material is the rate of change of the index of refraction with respect to wavelength, that is dn/d$\lambda$.

For all optical systems employing a plurality of different materials having different Abbe numbers a "median Abbe number" may be defined. The "median Abbe number" may be determined in analogy to statistics as a number dividing a higher half of sample from a lower half. The median of a finite list of numbers can be found by arranging all the numbers of the finite list from the lowest value to the highest value and picking the middle one of the elements which determines the median value. If there is an even number of numbers on the list, the median is defined, for the purpose of this application, as the mean value of the two middle values. For example, if 60% of all the lenses of the plurality of lenses are made from one and the same first material, and 40% are made from the second material, then the median Abbe number is the Abbe number of the first material.

At least one of the plurality of lenses is a first lens made from a first material having a first Abbe number equal to or greater than the median Abbe number and at least one of the plurality of lenses is made from a second material having an Abbe number smaller than the median Abbe number. For the purpose of this application, the first material (having the relatively greater Abbe number, generally corresponding to a relatively smaller dispersion) will be denoted as "relative crown material" or simply "crown material", whereas the second material having the relatively smaller Abbe number (generally corresponding to relatively higher dispersion) will be denoted as "relative flint material" or, simply, "flint material".

It has been found useful for the correction of axial chromatic aberration and chromatic variation of the image field curvature if at least two second lenses (made from the second material) are negative lenses. With other words: at least two negative lenses made from a second material (i.e. relative flint material) combined with lenses made of relative crown material may be a powerful means to correct chromatic aberration of image field curvature.

Negative lenses made of relative flint material should be-distributed within the objective in at least two optically separate regions distinguished by substantially different values of the relative marginal ray heights.

At least one of the negative lenses should be a first negative lens arranged in a region of relatively small marginal ray height where a marginal ray height is less than 70% of a maximum marginal ray height in the objective. The marginal ray height may be less than 60% or even less than 50% of the maximum marginal ray height. A first negative lens may therefore have a relatively small lens diameter.

It may be preferable that a first negative lens has relatively strong refractive power. Therefore, although the first negative lens may be designed as a meniscus lens, in some embodiments at least one first negative lens is a biconcave negative lens. The first negative lens may be a plano-concave lens.

Arranging a first negative lens in a region of relatively small marginal ray height allows designing the negative lens with relatively strong negative refractive power while at the same time the contribution of the negative lens to the overall refractive power of the objective may be kept relatively small such that it is not necessary to provide high power positive lenses to compensate the dispersive effect of the negative lens.

Unlike negative lenses which are primarily provided to support correction of axial chromatic aberration (AX) a negative lens dedicated to support correction of chromatic variation of image field curvature should be relatively small in diameter, e.g. when compared to adjacent lenses. The negative lens may have an optically free diameter substantially smaller than an optically free diameter of at least one lens directly adjacent to the negative lens. For example, the negative lens may be arranged between two adjacent lenses, where each of the two adjacent lenses has an optically free diameter substantially larger than the optically free diameter of the negative lens, e.g. by at least 10% or at least 20%. In some embodiments, the negative lens has an optically free diameter which is less than 80% of an optically free diameter of a largest lens (lens having the largest optically free diameter) of the objective. The optically free diameter of the negative lens may be less than 70% and/or less than 60% and/or less than 50% of the optically free diameter of the largest lens of the objective.

In some embodiments the objective includes at least one waist region where a beam diameter of a radiation beam passing through the objective has a local minimum and a first negative lens (made of relative flint material) is positioned in the waist region.

A negative lens as mentioned above may also be positioned close to a field surface of the objective, such as the object surface or the image surface. In embodiments having one or more real intermediate images, a negative lens may be positioned close to the intermediate image.

Although one single first negative lens made of relative flint material may be sufficient to correct chromatic variation of the image field curvature in some embodiments, other embodiments have at least two first negative lenses of the second material. More than two first negative lenses of a second material may be provided if desired. The first negative lenses may be made from the same or different relative flint materials.

Further, at least one of the negative lenses should be a second negative lens arranged in a region of relatively large marginal ray height where a marginal ray height is more than 70% of a maximum marginal ray height in the objective. The marginal ray height may be more than 75% or even more than 80% or more than 85% of the maximum marginal ray height. A second negative lens may therefore have a relatively large lens diameter.

In some embodiments, the second negative lens has an optically free diameter which is more than 80% of an optically free diameter of a largest lens (lens having the largest optically free diameter) of the objective. The optically free diameter of the second negative lens may be more than 90% of the optically free diameter of the largest lens of the objective.

The second negative lens may be arranged in a region optically close to a pupil surface of the objective where a chief ray height is less than 50% of a maximum chief ray height in the objective.

A second negative lens of relative flint material arranged in a region of relatively large relative marginal ray height may be designed as a strong means to support correction of axial chromatic aberration (AX).

The second negative lens may be designed as a meniscus lens. In some embodiments the negative lens is a biconcave negative lens. The second negative lens may be a plano-concave lens.

The second negative lens may be combined with at least one positive lens made of the first material and arranged directly adjacent to the second negative lens to form a lens doublet. The positive lens counteracts the diverging power of the second negative lens and contributes to keeping the overall power of the doublet positive.

In some embodiments the optical elements include a lens doublet consisting of a first lens and a second lens directly adjacent to the first lens, wherein the first lens is a positive lens made from a first material and the second lens is a second negative lens made from a second material, wherein the lens doublet is arranged in a region optically close to a pupil surface of the projection objective where a chief ray height CRH is less than half the marginal ray height MRH in the objective, i.e. where $|CRH|/|MRH| < 0.5$. In some cases the chief ray height is less than 50% of a maximum chief ray height in the objective at the lens doublet.

A positive lens made from a first material may be arranged directly adjacent to the second negative lens of the lens doublet on a side opposite to the first lens of the lens doublet to increase the converging power in the region of the second negative lens made of relative flint material.

One or both positive lenses directly adjacent to the second negative lens may be a biconvex positive lens.

According to another formulation there is provided a catadioptric objective comprising a plurality of optical elements arranged along a single straight optical axis to image a pattern from an off-axis object field in an object surface of the objective to an off-axis image field in an image surface region of the objective at an image-side numerical aperture NA with electromagnetic radiation from a wavelength band around a central wavelength $\lambda$. The optical elements include a concave mirror and a plurality of lenses. The projection objective forms an image of the pattern in a respective Petzval surface for each wavelength $\lambda$ of a wavelength band, the Petzval surfaces deviating from each other for different wavelengths. A longitudinal departure p of the Petzval surface at a given wavelength from a planar reference surface at an edge field point of the image field (at maximum image height y'), measured parallel to the optical axis in the image surface region, varies with the wavelength $\lambda$ according to $dp/d\lambda < (\lambda/NA^2)$ / nm.

Preferably, the variation $dp/d\lambda$ is smaller, e.g. such that the condition $dp/d\lambda < (0.5\ \lambda/NA^2)$ / nm or the condition $dp/d\lambda < (0.2\ \lambda/NA^2)$ / nm is fulfilled.

According to another formulation there is provided a catadioptric objective comprising a plurality of optical elements arranged along a single straight optical axis to image a pattern from an off-axis object field in an object surface of the objective to an off-axis image field in an image surface region of the objective at an image-side numerical aperture NA with electromagnetic radiation from a wavelength band around a central wavelength $\lambda$. The optical elements include a concave mirror and a plurality of lenses. The objective forms a first image of the pattern in a first Petzval surface at a first wavelength $\lambda_1 < \lambda$ of the wavelength band and a second image of the pattern in a second Petzval surface at a second wavelength $\lambda_2 > \lambda$ separated from the first wavelength by a wavelength difference $\Delta\lambda = \lambda_2 - \lambda_1$ greater than 2 nm. A longitudinal Petzval surface departure $\Delta PS$ between the first Petzval surface and the second Petzval surface, measured parallel to the optical axis in the image surface region, is less than $\lambda/NA^2$ for all field points in the image field.

Every optical system has associated with it a sort of basic field curvature, which is conventionally called the Petzval curvature. When there is no astigmatism, the sagittal and tangential image surfaces coincide with each other and lay on the Petzval surface. Positive lenses (lenses with positive refractive power) introduce inward curvature of the Petzval surface to a system, and negative lenses (lenses with negative refractive power) introduce backward curvature. The Petzval curvature, $1/R_P$, is given by the Petzval sum $1/R_P$, which is the reciprocal of the Petzval radius $R_P$, which is the radius of curvature of the Petzval surface. The Petzval sum of dioptric (refractive) optical elements may be defined as follows:

$$\frac{1}{R_P} = -n_{img} \sum_i \frac{1}{r_i}\left( \frac{1}{n_i} - \frac{1}{n_{i-1}} \right) \qquad (1)$$

In this equation, $R_P$ is the radius of curvature of the Petzval surface in the image space, $n_{img}$ is the refractive index in the image space, $r_i$ is the radius of curvature of the $i^{th}$ system surface (positive if convex towards the incoming radiation), and $n_i$ and $n_{i-1}$ are the refractive indices of the medium downstream and upstream of the $i^{th}$ system surface. In the absence of astigmatism, the Petzval curvature corresponds to the curvature of the image surface. For reflective surfaces (mirrors) the condition $n_i = -n_{i-1}$ holds such that:

$$\frac{1}{R_P} = n_{img} \sum_i \frac{2}{r_i \cdot n_i} \quad , \qquad (2)$$

wherein $n_i$ is the refractive index of the medium surrounding the mirror surface. Equations (1) and (2) show that the condition $R_P < 0$ holds for a positive lens, corresponding to an inward curvature of the Petzval surface. Therefore, the image of a planar object will be concave towards the radiation direction, which condition is typically referred to as "undercorrection" of field curvature. In contrast, the condition $R_P > 0$ holds for a concave mirror, corresponding to overcorrection of the field curvature.

The Petzval surface and the paraxial image surface coincide on the optical axis. The curvature of the Petzval surface may result in a situation where the Petzval surface departs from the ideal image surface for field points further away from the optical axis. The fact that the Petzval surface is curved transforms to a longitudinal departure p of the Petzval surface from the ideal image surface (which is usually flat) at a field point at the outer edge of the image field (at maximum image field height y'), measured parallel to the optical axis in the image space. The term "image field curvature" is conventionally used to refer to such longitudinal departure (or sag) at maximum image field height y', and may not be confused with the "curvature of the image field", which is the reciprocal of the radius of curvature of the image field.

Generally, the image field curvature will be different for different wavelengths, corresponding to a "chromatic variation of image field curvature" (or chromatic variation of the Petzval sum) of an optical system. With other words: the image field curvature (or the Petzval sum) is a function of the wavelength $\lambda$. Considering an optical system having lenses made from one material only (one-material system) equation (1) may be reformulated using parameter $n_g$ for the refractive index of all the lenses and parameter $n_a$ for the refractive index of the medium in the spaces between lenses according to:

$$\frac{1}{R_P} = \left( \frac{1}{n_g} - \frac{1}{n_a} \right) n_{img} \cdot \sum_{lenses} \left( \frac{1}{r_{i,1}} - \frac{1}{r_{i,2}} \right) \tag{3}$$

$$\frac{1}{R_P} = \left( \frac{1}{n_g} - \frac{1}{n_a} \right) n_{img} \cdot G \text{ , with} \tag{3a}$$

$$G = \sum_{lenses} \left( \frac{1}{r_{i,1}} - \frac{1}{r_{i,2}} \right) \tag{3b}$$

$$\frac{d}{d\lambda} \left( \frac{1}{R_P} \right) = \left( -\frac{1}{n_g^2} \right) n_{img} \cdot G \cdot \frac{dn_g}{d\lambda} \tag{3c}$$

Equation (3) gives the dioptric contribution to the system Petzval sum. In the sum term on the right hand side of equation (3), parameters $r_{i,1}$ and $r_{i,2}$ refer to the radius of curvature of the entry surface and the exit surfaces of the lenses, respectively. It is apparent that the sum term in the product on the right hand side of the equation (3), corresponding to sum term G as defined in equation (3b), describes a purely geometrical property of the optical system, whereas the first factor of the product in equation (3) includes the refractive index of the lenses, is generally different from zero and varies with the wavelength. Therefore, if the sum term (purely geometrical term G) differs from 0, and if the transparent material used for the lenses is a dispersive material (index of refraction varies with wavelength) then the contribution to Petzval sum given in equation (3) varies with the wavelength as given in equation (3c) assuming that the dispersion of the medium adjacent to the mirrors is negligible.

As evident from equation (2), the contribution to Petzval sum of reflective surfaces does not depend on the wavelength as long as the reflective surfaces lie in a substantially dispersion-free medium such as air or another gas. Therefore, the entire chromatic variation of the Petzval sum in a catadioptric optical system equals the chromatic variation of the Petzval sum of the dioptric (refractive) optical components of the optical system.

As outlined above, the Petzval sum is a parameter representing the curvature of the image field in which an image with optimum quality is generated (if no other aberrations such as astigmatism exist). Where it is desired to determine whether or not a given image field curvature is acceptable for an optical system the problem may be described as follows. A longitudinal departure p of the Petzval surface from a reference image surface at an edge field point of the image field at image height y' measured parallel to the optical axis in the image surface region, may be written as follows:

$$p = \frac{1}{2R_P} y'^2 \qquad\qquad (4)$$

where Rp is the Petzval radius (radius of the Petzval surface). The longitudinal departure p effectively corresponds to a defocus at the outer edge of the image field from a reference surface, which may be a planar surface perpendicular to the optical axis or a surface of another shape. Where it is desired to obtain a diffraction limited image across the entire image field this defocus (longitudinal departure) must not exceed a predefined fraction of the depth of focus (DOF), which is proportional to the Rayleigh unit RU defined as:

$$RU = \frac{\lambda}{NA^2} \qquad\qquad (5)$$

Therefore, the defocus resulting from the Petzval sum should not exceed a given threshold value according to:

$$p < A \cdot \frac{\lambda}{NA^2} \qquad\qquad (6)$$

Generally, the condition A<1 should hold if diffraction limited imaging is desired for all wavelengths.

Where the Petzval sum varies with the wavelength, the longitudinal departure p defined above also varies with the wavelength such that the derivative of p with respect to wavelength $\lambda$, dp/d$\lambda$, has a finite value differing from zero. The derivative of p with respect to wavelength $\lambda$, dp/d$\lambda$, may be used to characterize the magnitude of the chromatic variation of image field curvature in an optical system. The derivative of p with respect to wavelength $\lambda$, dp/d$\lambda$, should not exceed a threshold value B in the wavelength band of intended use such that

$$dp/d\lambda < B \qquad\qquad (7)$$

In broadband applications, where it is desired to use at least two wavelengths $\lambda_1$ and $\lambda_2$ spaced apart by the wavelength difference $\Delta\lambda$ condition (6) may be reformulated as

$$dp/d\lambda * \Delta\lambda < A*1RU \qquad\qquad (8)$$

Where the objective is configured to be used as a projection objective in a microlithographic system it may be desirable that the images formed for different wavelengths lay relatively close together in a common image field region and the common image field region is essentially flat in an area large enough to allow economic manufacturing of components. In those embodiments the objective may be configured to reduce an image field curvature for each of the first and second wavelength in the image region to less than a depth of focus of the objective. The depth of focus (DOF) is proportional to the Rayleigh unit RU = $\lambda$/NA$^2$.

In some embodiments the image field has an image field size defined by a maximum image field height y' greater than 3 mm. Twice the maximum image field height corresponds to the image field diameter which may actually be used for lithographic purposes, for example. The maximum image field height y' may be 5 mm or more, or 8 mm or more, or 10 mm or more, or 15 mm or more for example.

Embodiments may have an image-side numerical aperture NA > 0.2, thereby allowing use in microlithography, for example. In some embodiments an image-side numerical aperture NA > 0.3 or NA > 0.4 or NA ≥ 0.5 is obtained. The image-side numerical aperture may be even greater, such as NA ≥ 0.6 or NA ≥ 0.7 or NA ≥ 0.8 or NA ≥ 0.9. Embodiments may be used in an immersion configuration, thereby allowing NA≥1.0 in cases where the objective is configured for such immersion operation.

The wavelength band may include wavelengths $\lambda \geq 300$ nm. For example where primary radiation is provided by a mercury vapour radiation source the wavelength band may include one of the mercury g-, h- and i-lines. The wavelength band may include wavelengths $\lambda < 300$ nm, such as $\lambda < 260$ nm or $\lambda < 200$ nm, for example. The wavelength may be larger than 100 nm or larger than 150 nm. Wavelengths smaller than 300 nm may be provided by a laser radiation source.

The wavelength band may include radiation of one spectral line region only, where a considerable amount of energy of the spectral line region may be used. The wavelength difference $\Delta\lambda$ may be 0.1 nm or more or 1 nm or more or 2 nm or more in some cases. Larger wavelength differences are possible, such as $\Delta\lambda > 5$nm.

In achromatic systems according to embodiments the allowable spectral width of the primary radiation source roughly scales quadratically with the image-side NA. For example, as a guideline, the allowable spectral width may be 2 nm or less at NA = 0.8. In many high NA applications (e.g. NA$\geq$0.6) the wavelength differences may be in the order of 5nm or less (i.e. $\Delta\lambda \leq 5$nm ).

Catadioptric objectives useful for broadband application with sufficient control of the chromatic variation of image field curvature may be configured in a variety of ways.

One single concave mirror may be sufficient in some embodiments. In other embodiments more than one concave mirror is used. In this case, further degrees of freedom with regard to correction of aberrations are obtained. Preferably, the optical elements include an even number of concave mirrors. In this case, the projection objective may be designed as an in-line system having one straight optical axis common to all optical elements. No planar folding mirrors are necessary, thereby avoiding e.g. polarization effects introduced by planar folding mirrors. Projection objectives having exactly two concave mirrors facing each other may be favorable since a parallel alignment of object surface and image surface and a straight optical axis can be obtained with a minimum number of concave mirrors. Designs with more than two concave mirrors, e.g. three, four, five or six concave mirrors are also possible.

Preferred embodiments have at least one (real) intermediate image. Providing at least one intermediate image allows higher flexibility with regard to correction of imaging aberrations, since the correction of aberrations may be obtained by compensating effects of more than one imaging objective part.

Some embodiments include a first, refractive objective part for imaging the pattern provided in the object surface into a first intermediate image; a second objective part including at least one concave mirror for imaging the first intermediate image into a second intermediate image; and a third, refractive objective part for imaging the second intermediate image onto the image surface. The first refractive objective part allows to create the first intermediate image having a desired position, size and corrections status. These parameters can be adjusted such that favorable imaging by the catoptric or catadioptric second objective part into the second intermediate image is possible. The third, refractive objective part may be optimized to compensate residual aberrations of the second intermediate image and to provide the desired image-side numerical aperture NA and effective image field size.

The second objective part may be catoptric (consisting of mirrors only) or catadioptric, combining a concave mirror with at least one lens. For example, one or more negative lenses may be placed in front of a concave mirror situated close to or at the pupil surface of the second objective part to provide a major contribution to color correction. The second objective part may include one concave mirror only. In preferred embodiments, a first concave mirror having a first continuous mirror surface and at least one second concave mirror having a second continuous mirror surface are arranged in the second objective part. Preferably, pupil surfaces are formed between the object surface and the first intermediate image, between the first and the second intermediate image and between the second intermediate image and the image surface; and all concave mirrors are arranged optically remote from a pupil surface. Ultra-high resolution catadioptric projection objectives of this general construction are disclosed e.g. in US 2005/0190435A1 by the applicant. The disclosure of this document is incorporated herein by reference.

The previous and other properties can be seen not only in the claims but also in the description and the drawings, wherein individual characteristics may be used either alone or in sub-combinations as an embodiment of the invention and in other areas and may individually represent advantageous and patentable embodiments.

BRIEF DESCRIPTION OF THE DRAWINGS

Fig. 1     shows a schematic drawing of an embodiment of a projection exposure apparatus for microlithography having an illumination system and a projection objective;

Fig. 2     shows a schematic drawing of a projection exposure apparatus with a mercury vapor radiation source and a chromatically corrected projection objective in Fig. 2A, different radiation spectra in Fig. 2B and 2C, and an illustration related to the image field size and shape in Fig. 2D.

Fig. 3     shows a first embodiment of a catadioptric projection objective in Fig. 3A and diagrams representing optical properties of the embodiment in Fig. 3B to 3D;

Fig. 4     shows a second embodiment of a catadioptric projection objective in Fig. 4A and diagrams representing optical properties of the embodiment in Fig. 4B to 4D;

DETAILED DESCRIPTION OF THE PREFERRED EMBODIMENTS

In the following description of preferred embodiments, the term "optical axis" refers to a straight line passing through the centers of curvature of optical elements. In the examples presented below, the object is a mask (reticle) bearing the pattern of a layer of an integrated circuit or some other pattern, for example, a grating pattern. The image of the object is projected onto a wafer serving as a substrate that is coated with a layer of photoresist, although other types of substrates, such as components of liquid-crystal displays or substrates for optical gratings, are also feasible.

Where tables are provided to disclose the specification of a design shown in a figure, the table or tables are designated by the same numbers as the respective figures. Corresponding features in the figures are designated with like or identical reference identifications to facilitate understanding. Where lenses are designated, an identification L3-2 denotes the second lens in the third objective part (when viewed in the radiation propagation direction).

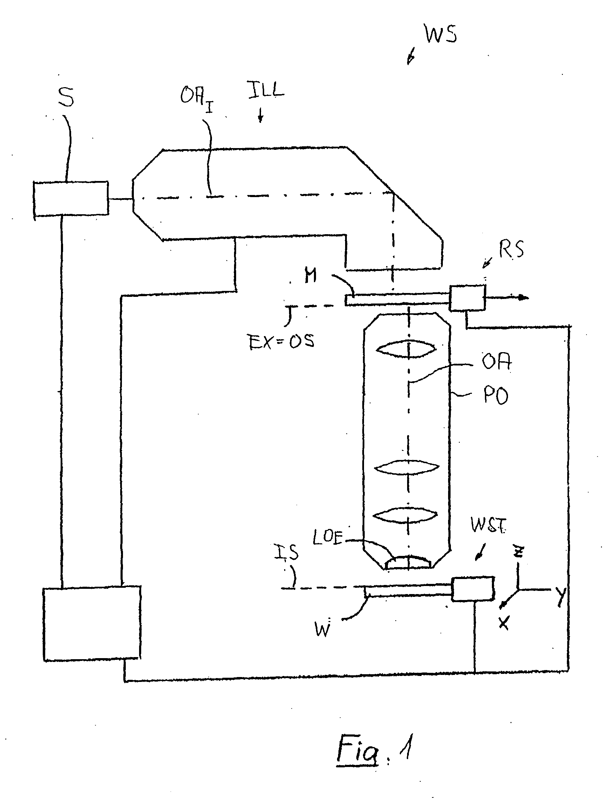

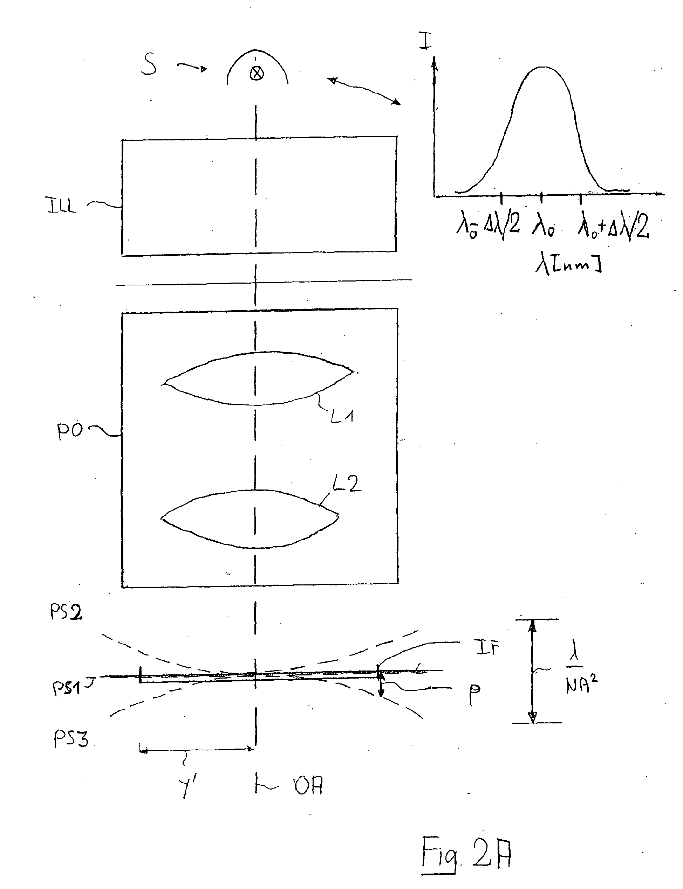

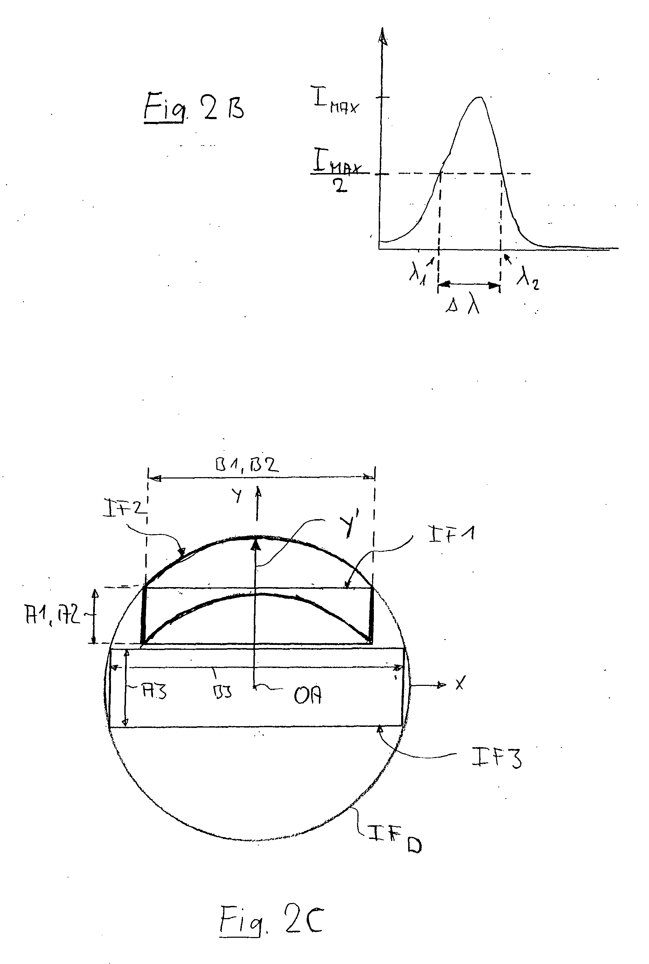

Figure 1 schematically shows a microlithography projection exposure apparatus in the form of a wafer scanner WS set up for producing specific layers of large-scale integrated semiconductor components and permits exposures with a resolution capability of down to R = 180nm or lower depending on the illumination mode. A primary radiation source S of the exposure apparatus includes a high power mercury-arc lamp emitting ultraviolet radiation in a wavelength band including the mercury i-line at about 365 nm (compare Fig. 2). The layout of other embodiments may be adapted to operate with one of the other mercury lines, e.g. the mercury g-line at about 436 nm or the mercury h-line at about 405 nm.

A downstream illumination system ILL receives the light from the primary radiation source S and generates, in its exit plane EX, a large, sharply delimited, homogeneously illuminated illumination field that is adapted to the telecentricity requirements of the projection objective PO and is centered about the optical axis $OA_I$ of the illumination system. The illumination system ILL has devices for setting the illumination mode and, in the example, can be changed over between conventional illumination with a variable degree of coherence, annular illumination and dipole or quadrupole illumination.

Arranged between the exit-side last optical element of the illumination system and the entrance of the projection objective is a device RS for holding and manipulating a mask M such that a pattern - arranged on the mask - of a specific layer of the semiconductor component to be produced lies in the object plane OS of the projection objective, said object plane coinciding with the exit plane EX of the illumination system. The optical axis $OA_I$ of the illumination system and the optical axis OA of the projection objective PO are laterally offset relative to one another in order to produce an off-axis field in relation to the optical axis OA of the projection objective. The device RS - usually referred to as "reticle stage" - for holding and manipulating the mask contains a scanner drive enabling the mask to be moved parallel to the object surface OS of the projection objective or perpendicular to the optical axis of projection objective and illumination system in a scanning direction (y-direction).

The projection objective PO follows in the radiation path downstream of the plane EX, also designated as mask plane. The projection objective may be a reducing objective set up for imaging a demagnified image of the structure borne by the mask on a reduced scale, for example on a scale of 4:1 or 5:1 or 10:1, onto a wafer W coated with a photoresist layer. The projection objective may be a unit magnification (1:1) system. The wafer W serving as a light-sensitive substrate is arranged in such a way that its planar substrate surface coincides with the planar image surface (image plane) IS of the projection objective PO. The wafer is held by a device WST (wafer stage) comprising a scanner drive in order to move the wafer synchronously with the mask M in a fashion parallel to the latter.

The projection objective PO has a last optical element LOE as last, transparent optical component nearest the image surface IS. The exit surface of the last optical element is the last optical surface of the projection objective, being arranged at a working distance of a few millimetres above the substrate surface of the wafer in such a way that there is a gas-filled gap situated between the exit surface of the projection objective and the substrate surface (dry system). In other embodiments an immersion system may be used where the working distance between the last optical element LOE and the wafer is filled with an immersion liquid (e.g. water). The last optical element LOE may be a plano-convex lens, providing a planar exit surface. In some embodiments, the last optical element may be formed by a plane parallel plate, equally providing a planar exit surface of the projection objective. The exit surface of the projection objective may also be curved. Such curved exit surface may be provided by a last optical element formed like a biconvex lens, for example. In some embodiments the last optical surface (exit surface of the projection objective) may be concave.

The projection objective PO may be designed as a reducing objective or as a 1:1 objective. The objective has, in addition to a plurality of schematically indicated lenses (typical numbers of lenses are often more than 10 or more than 15 lenses) and, if appropriate, other transparent optical components, a (at least one) concave mirror.

For many applications in the field of microlithograpy the image-side numerical aperture of the projection objective is NA>0.6, and in many embodiments NA is between approximately NA=0.65 and NA=0.85 or NA = 0.9. As a result, typical resolutions of down to R=180nm or below are possible at the operating wavelength predefined by the radiation source S. Typical resolutions down to about 150nm, or 130nm, or 100nm, or 90nm or less are also possible basically depending on the combination of image-side NA and the wavelength of the radiation source.

In order for the projection objective to function properly at a given wavelength or a given plurality of wavelengths within a desired wavelength band the projection objective must be configured to allow an exposure of substrates utilizing light from the wavelength band for which the projection objective is designed. This wavelength band may be denoted as "design wavelength band" and denotes a range of wavelengths including those wavelengths for which the optical performance of the projection objective is sufficiently good to allow diffraction limited imaging with relatively low aberration level. For example, where the configuration of the projection objective is such that the design wavelength band includes the mercury i-line, the projection objective may be used in conjunction with a high power mercury-arc lamp as a light source of the projection exposure apparatus. Therefore, a projection objective configured for use with a mercury-arc lamp should be optimized for at least one of the mercury lines at about 365 nm (i-line), about 405 nm (h-line) and about 436 nm (g-line), whereas the optical performance may deteriorate significantly outside the design wavelength band.

A projection objective may be designed such that a useful image is formed for only one wavelength in a relatively narrow wavelength band. Embodiments described in this application are corrected to operate at two or more wavelengths spaced apart by a wavelength difference $\Delta\lambda$. The wavelength difference may be about 50 pm (50 picometers) or more, or 100 pm or more, or 1 nm (1 nanometer) or more, 2 nm or more, for example. The exemplary embodiment of Fig. 2 is chromatically corrected for wavelengths essentially corresponding to the wavelength of the mercury i-line, which corresponds to a wavelength difference $\Delta\lambda$ of about 2 nm to 5 nm (natural line width (Full Width at Half Maximum, FWHM). Other mercury lines, such as the g-line or the h-line, may be used for exposure if the design is modified correspondingly.

As outlined above, every optical imaging system designed to provide an image in an image field region has associated with it a sort of basic field curvature, conventionally denoted as Petzval curvature. The Petzval curvature is proportional to the Petzval sum $1/R_P$, which is the reciprocal of the Petzval radius $R_P$, which is the radius of curvature of the Petzval surface. Where the optical system includes refractive optical elements, such as lenses L1, L2, the image field curvature may be different for different wavelengths, which effect is denoted here as "chromatic variation of image field curvature". With other words: the objective forms a first image of a pattern in a first Petzval surface PS1 at a first wavelength $\lambda_1$ of a wavelength band, and a second image of the pattern in the second Petzval surface PS2 at a second wavelength $\lambda_2 > \lambda_1$, where the first and second Petzval surface do not coincide. This situation is shown schematically in Fig. 2A, where projection objective PO generates a first Petzval surface PS1 for $\lambda_0 = 365$ nm (i-line), a second Petzval surface PS2 for $\lambda_1 = \lambda_0 - \Delta\lambda/2$ and a third Petzval surface PS3 for $\lambda_2 = \lambda_0 + \Delta\lambda/2$. In the exemplary embodiment the design of the projection objective is configured such that the Petzval surface of the intermediate wavelength $\lambda_0 = 365$ nm is essentially planar and coincides with the planar image surface IS of the projection objective (where the planar radiation entry side of the substrate is arranged in a lithographic process). Under these conditions, the Petzval surface PS2 for the relatively shorter wavelength is curved inwardly (concave towards the projection objective, i.e. undercorrected), whereas the Petzval surface PS3 of the greater wavelength has the opposite sense of curvature.

In the exemplary system of Fig. 2A, the Petzval surfaces of all three wavelengths essentially coincide with the axial position of the image surface IS on the optical axis OA. This corresponds to a good correction status where the axial chromatic aberration (AX) is essentially corrected for the three wavelengths $\lambda_0$, $\lambda_1$ and $\lambda_2$. The remaining secondary spectrum is assumed to be negligible in this case. However, the situation is different for field points at the outer edges of the effective image field IF corresponding to field points having a maximum image field height y'. Due to the bending of the Petzval surfaces, a longitudinal departure p (also denoted as sag) of the Petzval surface (measured parallel to the optical axis) for each of the largest and smallest wavelength is given at the edge field point. The longitudinal departure p effectively corresponds to a defocus at the outer edge of the image field IF from the planar image surface IS, which is a reference surface extending perpendicular to the optical axis in the image space. The magnitude of the departure p is given in equation (4) above. It may be seen qualitatively from Fig. 2A that such longitudinal departure may cause the image quality to deteriorate in regions close to the outer edges of an extended image field since the Petzval surfaces of different wavelength no longer coincide. A significant loss of contrast or a blurred image may therefore result in regions further a part from the optical axis, which effect becomes worse the larger the image field size (characterized by the maximum image field height Y') becomes. On the other hand, if the chromatic variation of the image field curvature is actively controlled by appropriate technical measures within the projection objective, an image with sufficient quality in the entire-image field IF may be obtained: Embodiments may be optimized in this regard by providing that the longitudinal departure p between the relevant Petzval surfaces corresponding to the wavelength used in the projection radiation is less than the Rayleigh unit RU = $\lambda/NA^2$ for all field points in the image field IF. Specifically, where all relevant Petzval surfaces lie within the region of the depth of focus DOF (which is proportional to RU) the image quality will normally be sufficient for all field points in the image field IF to allow diffraction limited exposure.

Note that Fig. 2A is purely schematic and not to scale for any of the features discussed in connection with Fig. 2A.

The meaning of some of the terms used in this application, such as the term "wavelength difference $\Delta\lambda$" and "maximum image field height y'" will now be explained in more detail in connection with Figs 2B and 2C.

Fig. 2B shows schematically the dependence of the intensity I of radiation source on the wavelength $\lambda$ in a region where a spectral line occurs in the spectrum. The spectral line may correspond to the mercury i-line at 365 nm, for example, which has the maximum value $I_{MAX}$ of intensity at about 365 nm. The wavelength difference $\Delta\lambda$" corresponds to the full width at half maximum (FWHM).

Where a laser radiation source is used, the wavelength of the maximum value of intensity, $I_{MAX}$, of the single spectral line may correspond to the nominal operating wavelength of the laser radiation source such, as about 193nm for a ArF laser, for example. It is evident that a corresponding value for the wavelength difference $\Delta\lambda$ becomes smaller where the radiation source is provided with specific means to narrow the natural bandwidth of the radiation source. For example, in case of using a mercury i-line, interference filters or the like may be used to narrow the natural band width of the mercury i-line. In the case of laser radiation sources, band width narrowing apparatus with relatively complex structure may be used to narrow the natural bandwidth of the laser.

Conditions on the image-side of the objective are now explained in connection with Fig. 2C. In embodiments of objectives intended to be used in a microlithographic process, a relatively large image field size is generally desired. For the purpose of this application the image field size may be characterized by a maximum image field height y', which corresponds to the radius of the (circular) "design image field" of the objective. The design image field $IF_D$ includes all field points of the image surface for which the imaging fidelity of the objective is sufficiently good for the intended lithographic process. With other words: all imaging aberrations are corrected sufficiently for the intended application within zones having radial coordinates equal to or smaller than the maximum image field height y', whereas one or more aberrations may be higher than a required threshold value for field points outside the design image field $IF_D$.

In general, not all field points within the design image field $IF_D$ are used for a lithographic process. Instead, exposure is only performed using field points lying within an effective image field IF, which should be sufficiently large in size to allow reasonably sized substrates to be exposed in a lithographic process. In many projection exposure systems, particularly those designed for a scanning operation, a slit-shaped effective image field IF is used and a pattern to be imaged as well as the substrate to be exposed are synchronously moved parallel to a scanning direction during a projecting step, the scanning direction corresponding to the y direction in the embodiment of Fig. 1. Fig. 2C shows two examples of effective off-axis image fields IF1, IF2 which may be utilized in connection with embodiments of catadioptric projection objectives as discussed here. The size of an effective image field may generally be described in terms of a length A parallel to the scanning direction and a width B>A perpendicular to the scanning direction, thereby defining an aspect ratio AR=B/A>1. In many embodiments the aspect ratio may be in the range from 2:1 to 10:1, for example.

The effective image field must fit into the design image field $IF_D$ in order to include only field points for which the objective is sufficiently corrected and for which no vignetting occurs. There are various ways to fit an effective image field into a design image field depending on the design of a catadioptric objective.

In the embodiments an effective image field having all field points outside the optical axis (so-called off-axis field) is used in order to avoid vignetting. First effective image field IF1 is an example of a rectangular off-axis effective image field having length A1 and width B1. In some embodiments, effective image fields with an arcuate shape (sometimes noted as annular field or ring field) such as second effective image field IF2 are used. Note that the first and second effective image fields, both situated entirely outside of and at a radial distance from the optical axis OA, have same length A1, A2 and width B1, B2, respectively. It is evident from Fig. 2C that the useful dimensions of an effective image field used for an exposure process may be larger the larger the maximum image field height Y' (also denoted as image field semidiameter) is.

For comparison only, third effective image field IF3 having length A3 and width B3 is an example of a centred effective image field fitting into the design image field $IF_D$. Centred image fields may be used for example in systems having a central pupil obscuration or in systems having a physical beam splitter, which systems are not considered here.

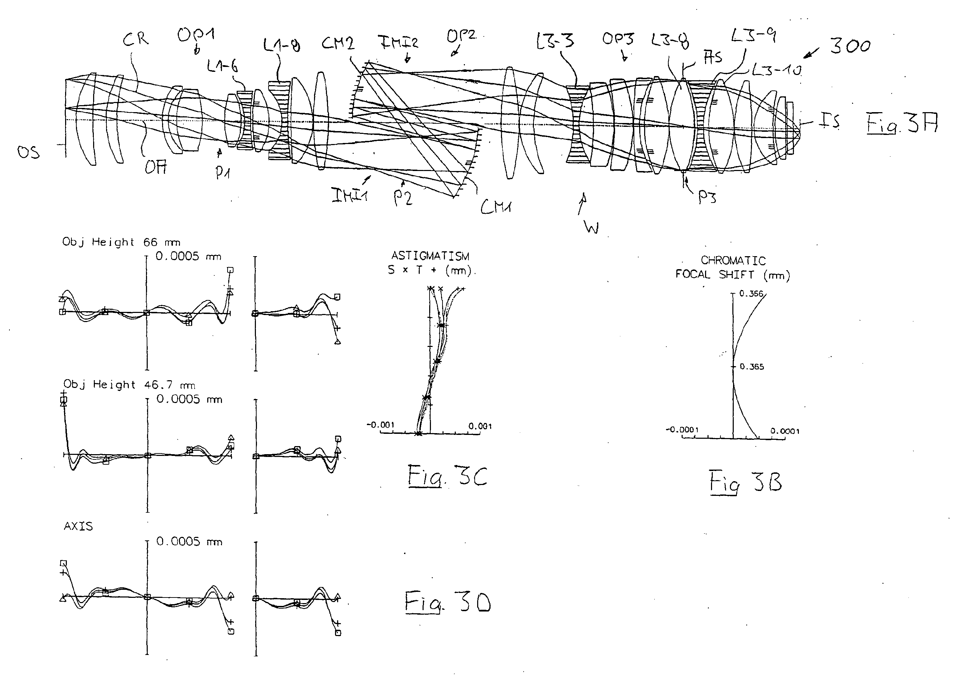

Fig. 3 shows a first embodiment of a catadioptric projection objective 300 designed for primary UV radiation including the mercury line at about 365 nm (i-line), i.e. an operating wavelength band with wavelengths spaced apart by at least a wavelength difference $\Delta\lambda$ = 2 nm. Given a demagnifying imaging scale of 4:1 ($\beta$=-0.25) the projection objective is telecentric on the object side and on the image side has an image-side numerical aperture NA=0.80. The image field size is 26 mm by 5.5 mm. The specification is given in tables 3, 3A.

Projection objective 300 is designed to project an image of a pattern on a reticle arranged in the planar object surface OS (object plane) into the planar image surface IS (image plane) on a reduced scale, for example, 4:1, while creating exactly two real intermediate images IMI1, IMI2. The rectangular effective object field OF and image field IF are off-axis, i.e. entirely outside the optical axis OA. A first refractive objective part OP1 is designed for imaging the pattern provided in the object surface into the first intermediate image IMI1. A second, catadioptric (refractive/reflective) objective part OP2 images the first intermediate image IMI1 into the second intermediate image IMI2 at a magnification close to 1:(-1). A third, refractive objective part OP3 images the second intermediate image IMI2 onto the image surface IS with a strong reduction ratio.

Projection objective 300 is an example of a "concatenated" projection objective having a plurality of cascaded objective parts which are each configured as imaging systems and are linked via intermediate images, the image (intermediate image) generated by a preceding imaging system in the radiation path serving as object for the succeeding imaging system in the radiation path. The succeeding imaging system can generate a further intermediate image (as in the case of the second objective part OP2) or forms the last imaging system of the projection objective, which generates the "final" image field in the image plane of the projection objective (like the third objective part OP3). Systems of the type shown in Fig. 3 are sometimes referred to as R-C-R system, where "R" denotes a refractive imaging system and "C" denotes a catadioptric (or catoptric) imaging system.

The path of the chief ray CR of an outer field point of the off-axis object field OF is indicated in Fig. 3 in order to facilitate following the beam path of the projection beam. For the purpose of this application, the term "chief ray" (also known as principal ray) denotes a ray running from an outermost field point (farthest away from the optical axis) of the effectively used object field OF to the center of the entrance pupil. Due to the rotational symmetry of the system the chief ray may be chosen from an equivalent field point in the meridional plane as shown in the figures for demonstration purposes. In projection objectives being essentially telecentric on the object side, the chief ray emanates from the object surface parallel or at a very small angle with respect to the optical axis. The imaging process is further characterized by the trajectory of marginal rays. A "marginal ray" as used herein is a ray running from an axial object field point (field point on the optical axis) to the edge of an aperture stop. That marginal ray may not contribute to image formation due to vignetting when an off-axis effective object field is used. The chief ray and marginal ray are chosen to characterize optical properties of the projection objectives. The radial distance between such selected rays and the optical axis at a given axial position are denoted as "chief ray height" (CRH) and "marginal ray height" (MRH), respectively. In so far as reference is made to a "marginal ray height" (MRH) or a "chief ray height" (CRH) in this application, this is taken to mean the paraxial marginal ray height and the paraxial chief ray height.

Values for the marginal ray height (MRH), the chief ray height (CRH), and the marginal ray height ratio MRHR, i.e. the relative marginal ray height $|MRH| / max(|MRH|)$ related to the maximum marginal ray height max(MRH) within the objective, are given in Tables 3C and 4C

Three mutually conjugated pupil surfaces P1, P2 and P3 are formed at positions where the chief ray CR intersects the optical axis. A first pupil surface P1 is formed in the first objective part between object surface and first intermediate image, a second pupil surface P2 is formed in the second objective part between first and second intermediate image, and a third pupil surface P3 is formed in the third objective part between second intermediate image and the image surface IS.

The second objective part OP2 comprises a first concave mirror CM1 having the concave mirror surface facing the object side, and a second concave mirror CM2 having the concave mirror surface facing the image side. The used parts of the mirror surfaces, i.e. those areas of the mirror surfaces which are illuminated during operation, are both continuous or unbroken, i.e. the mirrors do not have a hole or bore in the illuminated region. The mirror surfaces facing each other define a catadioptric cavity, which is also denoted intermirror space, enclosed by the curved surfaces defined by the concave mirrors. The intermediate images IMI1, IMI2 are both situated inside the catadioptric cavity well apart from the mirror surfaces.

The objective 300 is rotational symmetric and has one straight optical axis OA common to all refractive and reflective optical components ("In-line system"). There are no folding mirrors. An even number of reflections occurs. Object surface and image surface are parallel. The concave mirrors have small diameters allowing to arrange them close together and rather close to the intermediate images lying in between. The concave mirrors are both constructed and illuminated as off-axis sections of axial symmetric surfaces. The light beam passes by the edges of the concave mirrors facing the optical axis without vignetting. Both concave mirrors are positioned optically remote from a pupil surface rather close to the next intermediate image. The objective has an unobscured circular pupil centered around the optical axis thus allowing use as projection objectives for microlithography.

As a broadband radiation source is used, the projection objective should be capable of reducing the chromatic aberrations to an extent enabling a polychromatic imaging with sufficient quality in the entire image field for the lithographic application. For example, it is necessary to correct the primary chromatic aberrations such as the longitudinal chromatic aberration (AX) and the chromatic magnification aberration (LAT). Also, the chromatic variation of image field curvature should be sufficiently corrected.

As both concave mirrors CM1, CM2 are arranged optically remote from a pupil surface, a Schupman achromat may be used to correct chromatic aberrations, specifically axial chromatic aberration (AX).

A primary function of the two concave mirrors CM1 and CM2 is to correct the Petzval sum for the central wavelength $\lambda \sim 365$ nm. This enables that the dioptric parts of the objective may be designed radially compact (with relatively small lens diameters) and without a pronounced bulge-and-waist structure as known from Petzval sum correction in purely refractive objectives. As outlined above, the influence of the concave mirrors on Petzval sum does not vary with wavelength such that the mirrors have no contribution to the chromatic variation of Petzval sum. As evident from equations (3), (3a), (3b) and (3d) above, the Petzval sum is a purely geometrical property determined by the respective radii of curvature of the optical surfaces within the optical system. The radius of curvature of a lens or a mirror determines the refractive (or reflective) optical power of an optical surface. Therefore, a correlation exists between the radii of curvature and the optical power. Since the monochromatic Petzval sum of the optical system is substantially corrected and the concave mirrors provide an overcorrecting contribution to Petzval sum, the sum of the dioptric optical powers needs to have an undercorrecting effect, i.e. there is an excess of positive dioptric optical power within the optical system, which leads to a corresponding variation of Petzval sum with wavelength.

If the wavelength is varied, an increase of wavelength generally causes a decrease of the refractive index of a transparent material and, as a consequence, an undercorrection of Petzal sum of the entire optical system. This may be compensated for by providing that the change of refractive index within dioptric optical elements with wavelength is stronger in negative lenses of the optical system than in positive lenses. As a consequence, it is useful to have negative lenses made from relative flint material and positive lenses made from relative crown material. A particular distribution of those lenses is used in the embodiments to correct for both chromatic variation of the Petzval sum and axial chromatic aberration.

It has been found useful that the negative lenses of relatively high dispersion material predominantly dedicated to correcting chromatic variation of Petzval sum should be relatively small in diameter and should have relatively large refractive power. This may be understood as follows. As evident from equations (3) (3a) (3b) (3d) above, the Petzval sum is a purely geometrical property determined by the respective radii of curvature of the optical surfaces within the optical system. The radius of curvature of a lens or a mirror, however, determines the refractive (or reflective) optical power of an optical surface. Therefore, a correlation exists between the radii of curvature and the optical power. As mentioned above, one or more negative lenses made from a material with relatively high dispersion have been found to be effective to correct chromatic variation of Petzval sum. Therefore, one or more negative lenses made of relative flint material would be desirable. On the other hand, overall positive optical power is required for an imaging optical system, such as a projection objective useful for microlithography, to form an image of an object. In order to keep the optical system simple, negative refractive power should be avoided as much as possible within the objective. A reasonable compromise between those conflicting requirements may be obtained if the negative refractive power in high dispersion material (useful for correcting chromatic variation of Petzval sum) is provided by one or more negative lenses having relatively small optically free diameter. Where the optically free diameter of a negative lens is relatively small, the negative lens may have strong negative refractive power (relatively small radii of curvature of the optical surface) while at the same time the contribution to overall refractive power of the optical system may be kept relatively small due to the fact that the relatively small negative lens is only effective in a region of relatively small marginal ray height. With other words: where a negative lens with strong negative power is provided in a region of small marginal ray height (corresponding to a relatively small utilized free diameter of the negative lens), such negative lens may have a strong impact on the correction of chromatic variation of Petzval sum, while at the same time an undesirable influence on the imaging performed by the overall optical system may be kept relatively small.

This concept has been adopted in the embodiment of Fig. 3A. The embodiment has 24 lenses. The majority of the lenses is made from a special optical class designated as FK5 and sold by Schott, Mainz, Germany. Those lenses are shown without hatching. The optical system includes six negative lenses. Out of the negative lenses, all biconcave negative lenses L1-6, L1-8, L3-3 and L3-9 are made from a special optical glass denoted LF5 sold by Schott, Mainz, Germany. In this material combination, FK5 is a typical representative of a glass having relatively low dispersion (relatively high Abbe number, crown glass), while LF5 is a typical representative of a glass having relatively high dispersion (relatively low Abbe number, flint glass). Table A below summarizes some relevant properties, such as refractive index and Abbe number, for various transparent optical materials (left column) which may be used to form lenses in optical systems in the ultraviolet spectrum range (wavelength in top row).

## Table A

|        | 192.999  | 193.000  | 193.001  | 360.000  | 365.500  | 370.000  | 405.000  | 436.000  | ν (Abbe) |
|--------|----------|----------|----------|----------|----------|----------|----------|----------|----------|
| SILUV  | 1.560972 | 1.560970 | 1.560969 | 1.475299 | 1.474477 | 1.473834 | 1.469595 | 1.466705 | 60.4     |
| CAFUV  | 1.501396 | 1.501395 | 1.501394 | 1.445430 | 1.444863 | 1.444419 | 1.441484 | 1.439477 | 82.0     |
| FK5    |          |          |          | 1.504780 | 1.503934 | 1.503272 | 1.498902 | 1.495918 | 62.2     |
| LF5    |          |          |          | 1.621262 | 1.619068 | 1.617371 | 1.606590 | 1.599610 | 31.2     |
| LLF1   |          |          |          | 1.580929 | 1.579164 | 1.577796 | 1.569035 | 1.563301 | 35.9     |

The designation "SILUV" represents fused silica, the designation "CAFUV" represents calcium fluoride (CaF$_2$) and the designations FK5, LF5, and LLF1 represent special optical glasses sold by SCHOTT, Mainz, Germany. Similar or comparable glasses with similar optical properties provided by other sources, such as OHARA, may also be used. While fused silica and calcium fluoride are essentially free of absorption down to about 193 nm and below, the special glasses FK5, LF5 and LLF1 are predominantly used for wavelengths λ>300 nm, particularly for optical systems for the mercury i-line. The right column lists the Abbe numbers ν for the materials, calculated for the wavelength band including the mercury g-, h- and i-line according to the following equation:

$$\nu = \frac{n_{405} - 1}{n_{365.5} - n_{436}} \qquad (10)$$

where $n_{405}$, $n_{365.5}$ and $n_{436}$ are the refractive indices of the material at 405 nm, 365 nm and 436 nm, respectively.

It is evident from the Abbe numbers in table A that FK5 is the relative crown material (ν= 62.2), whereas LF5 is the relative flint material ν= 31.2) and that the Abbe number difference, Δν, is relatively large (Δν= 31.0). Since the majority of lenses (20 out of 24 lenses) are made from FK5, the median Abbe number corresponds to the Abbe number of FK5 (ν= 62.2).

Both biconcave lenses L1-6, L1-8 arranged in the first objective part between the first pupil surface P1 and the first intermediate image IMI1 are arranged in regions of relatively small marginal ray height, where the marginal ray height ratio MRHR between the amount of marginal ray height MRH at the respective lens and amount of the maximum marginal ray height max(MRH) given at the pupil surface P3 is about 41% for lens L1-6 and about 34% for lens L1-8. This arrangement allows those negative lenses to have strong negative refractive power, thereby strongly contributing to correction of chromatic variation of Petzval sum, while a negative influence on other properties within the system is kept small.

Further, biconcave negative lens L3-3 arranged in the third objective part between the second intermediate image IMI2 and the third pupil surface P3 contributes to correction of chromatic variation of Petzval sum. The marginal ray height in the region of this negative lens of flint material is about 45% of the maximum marginal ray height. The lens also provides some contribution to correction of axial chromatic aberration AX.

On the other hand, the objective also includes exactly one second negative lens made of relative flint material, which is arranged in the region of relatively large marginal ray height substantially more than 70% or 80% of the maximum marginal ray height. Biconcave negative lens L3-9 arranged immediately downstream of a third pupil surface P3 between the pupil surface and the image surface IS influences radiation at a marginal ray height about 90% to 95% of the maximum marginal ray height. Under these conditions a strong influence on axial chromatic aberration (AX) is obtained, while at the same time the influence on chromatic variation of the Petzval sum is relatively small. Second negative lens L3-9 of flint material is arranged between a biconvex positive lens L3-8 of relative crown material immediately upstream and a biconvex positive lens L3-10 of relative crown material immediately downstream of the second negative lens L3-9. A lens doublet configuration is thereby formed, which mallows to influence correction of axial chromatic aberration without significantly introducing overall negative refractive power in the converging beam downstream of the third pupil surface.

The chromatic variation of magnification (LAT) is substantially influenced by the refractive power distribution of the lenses upstream and downstream of the pupil positions and by the skilful positioning of the lenses in relation to the chief ray heights.

Since only a small fraction (less than 20%, namely 4 out of 24 lenses) are made from a second material with relatively high dispersion, only a small amount of a second material is used, which is advantageous in terms of costs and manufacturing.

According to the teaching outlined above, an effective contribution to correction of chromatic variation of Petzval sum may also be obtained by providing at least one negative lens from relative flint material in another position with relatively small marginal ray height, such as optically close to an intermediate image or optically close to the object or image surface, i.e. in a manner of a field lens. For example, a small negative lens made from relative flint material may be placed immediately upstream of the first intermediate image and/or immediately downstream of the second intermediate image. Such lenses may be provided alternatively or in addition to small negative lenses of flint material at other optical positions within in the optical system.

Alternatively, or in addition, the general concept may be used in such a way that one or more positive lenses made from a relative crown material (smaller dispersion than the majority of the other lenses) is provided in a region of relatively small marginal ray height, such as near a field surface. For example, in a projection objective having most or all lenses made from fused silica, a positive lens made from calcium fluoride may be placed optically near to one of the intermediate images IMI1 or IMI2, for example. For example, biconvex positive lens L3-1 immediately downstream of the second intermediate image IMI2 may be made from calcium fluoride instead of fused silica to support correction of chromatic variation of image field curvature.

Some relevant optical properties of the first embodiment in Fig. 3A are shown in figures 3B and 3D. The diagram of Fig. 3B shows the chromatic focal shift, i.e. the position of the focal plane with respect to the reference image plane for different wavelengths between 364 nm and 366 nm.

The curve exhibits one zero-crossing at about 365 nm essentially corresponding to the center of the mercury i-line and only little chromatic focal shift in a wavelength band of $\pm$ 1 nm (i.e. $\Delta\lambda$ = 2 nm) around the mercury i-line. With other words: the optical system of Fig. 3A is an achromatic system where axial chromatic aberration (AX) is corrected for a wavelength band of about $\Delta\lambda$ = 2 nm around the mercury i-line.

Figure 3C shows a diagram representing the chromatic variation of astigmatism. The abscissa relates to the defocus, the ordinate represents the field height in the image surface. The different curves represent different wavelengths in the spectrum between 364 nm and 366 nm.

Figure 3D shows various diagrams indicative of transverse aberrations as a function of wavelength between 364 nm and 366nm for different field heights. The left column represents the meridional plane. The lower diagram represents an axial field point, the upper diagram represents a field point at a maximum height and the middle diagram represents a zone field point lying in between. The right column represents the respective sagittal plane, where only one branch is shown due to the symmetry in this plane.

The diagrams show that relatively small variations of these aberrations with wavelength are obtained, indicating sufficient chromatic correction of the objective.

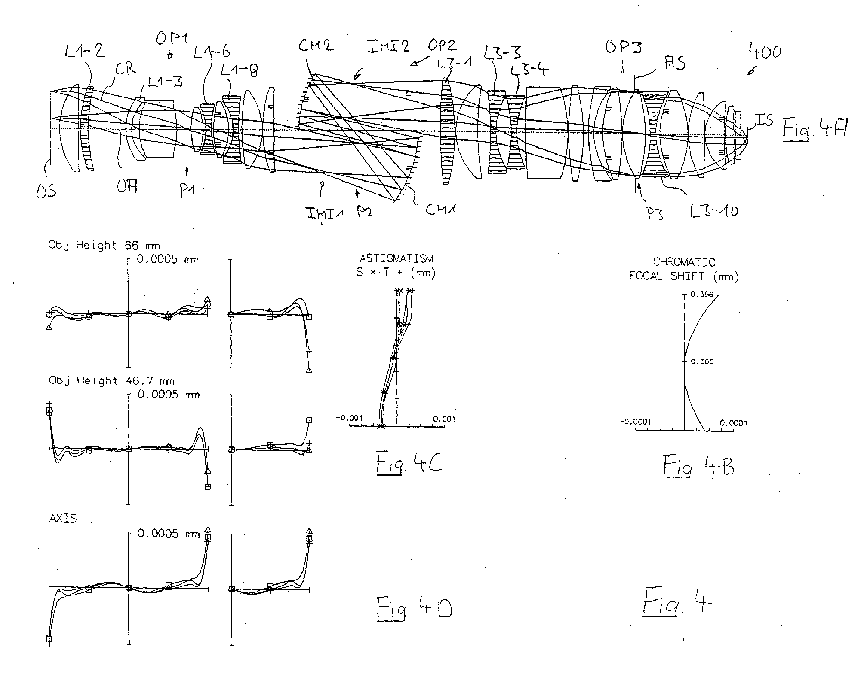

Figure 4 shows a second embodiment of a catadioptric projection objective. Projection objective 400 may be considered as a variant of the system shown in Figure 3A, having the similar general layout characterized by the fact that the objective is an in-line system (one single straight optical axis) having exactly two concave mirrors and exactly two intermediate images, and two concave mirrors each are optically remote from the pupil surface.

In this embodiment the polychromatic correction has been improved relative to the embodiment of Figure 3A basically by using additional lenses of relative flint material and additional lenses of another relative crown material. Employing more than one relative flint material and/or more than one relative crown material increases the degree of freedom in regard to correction of chromatic aberrations. However, the basic considerations with regard to correction of chromatic variation of Petzval sum and axial color are also used in this embodiment.

Specifially, two biconcave negative lenses L1-6 and L1-8 are provided in the first objective part OP1 in regions of relatively small marginal ray height (about 39% and about 36% of the maximum marginal ray height, respectively). Both lenses are made of LF5. Two biconcave second negative lenses L3-3 and L3-4 are arranged in the third objective part between second intermediate image IMI2 and third pupil surface P3 in the region of a pronounced waist W where the relative marginal ray height is about 41% (lens L3-3) and about 45% to 49% (lens L3-4) of the maximum ray height. While lens L3-4 is made of LF5, lens L3-3 arranged at relatively smaller marginal ray height is made of LLF1 having an Abbe number slightly larger than LF5. A balanced contribution to correction of chromatic variation of Petzal sum is thereby obtained.

Large biconcave negative lens L3-10 immediately downstream of a third pupil surface P3 and made of LF5 provides a major contribution to correction of axial chromatic aberration. The objective also includes two weak positive lenses L1-2 and L3-1 made of relative flint material, and each arranged optically close to a field surface.

Embodiments may be characterized by one or more of the following characteristics. An embodiment may have exactly two concave mirrors. The strongly curved concave mirrors may be figured to essentially correct the monochromatic Petzval sum, thereby allowing to provide a relatively high NA projection objective with moderate lens diameters and, as a consequence, relatively small material consumption. The dominant chromatic aberrations (axial chromatic aberration (AX) and chromatic variation of Petzval sum) may be corrected by using a limited amount of relative flint material in negative lenses provided at selected regions within the objective. The secondary spectrum may remain as the limiting aberration. Further correction of the secondary spectrum may be obtained, for example, by using one or more lenses made of a material with anormal dispersion, such as FK51 or calcium fluoride ($CaF_2$) and/or by using one or more diffractive optical elements.

A very efficient correction of monochromatic Petzval sum may be obtained by providing the two concave mirrors. Therefore, a maximum marginal ray height in dioptric objective parts, such as the third objective part OP3, may be significantly reduced when compared to purely dioptric objectives. This, in turn, provides that the secondary spectrum is decreased when compared to dioptric optical systems with comparable image-side NA and design wavelength band. Reduction of the secondary spectrum, in turn, may facilitate using a wider wavelength spectrum, thereby increasing the bandwidth of the optical design.

In the embodiments of Figure 3 and 4 special emphasis has been placed to the correction of the chromatic variation of the Petzval sum in the projection objective. For this purpose at least one lens of relative flint material and negative refractive power at marginal ray heights less than 70% of the maximal marginal ray height in the projection objective, i.e. with MRHR<0.7 is used.

The change of Petzval sum with wavelength may lead to a defocus dp of the field edge with respect to the field center with wavelength dλ. If that change is too large, the image quality at the edge of the field of view may degrade unacceptably. A limit for dp/dλ is given in equation (8). In the following table, the values for dp/dλ given in Rayleigh units RU= λ/NA² per nm wavelength shift dλ are evaluated for the two embodiments of Figs 3 and 4.

**Table B**

| Figure | 3 | 4 |
|---|---|---|
| dp/ dλ [RU/nm] | 0.007 | 0.125 |

The above description of the preferred embodiments has been given by way of example. From the disclosure given, those skilled in the art will not only understand the present invention and its attendant advantages, but will also find apparent various changes and modifications to the structures and methods disclosed. It is sought, therefore, to cover all changes and modifications as fall within the spirit and scope of the invention, as defined by the appended claims, and equivalents thereof.

The content of all the claims is made part of this description by reference.

The following tables summarize specifications of embodiments described above. In the tables, column 1 specifies the number of a refractive surface or a reflective surface or a surface distinguished in some other way, column 2 specifies the radius r (radius of curvature) of the surface (in mm), column 3 specifies the distance d - also denoted as thickness - between the surface and the subsequent surface (in mm), and column 4 specifies the material of the optical components. Column 5, 6 and 7 indicate the refractive index of the material for 3 different wavelengths 364 nm, 365 nm and 366 nm, and column 8 specifies the optically free radius or the optically free semidiameter (or the lens height) of a lens surface or other surfaces (in mm). Radius r=0 corresponds to a planar surface.

Columns 9 to 11 indicate the values for the amount of marginal ray height, |MRH|, the marginal ray height ratio MRHR=|MRH|/max(|MRH|, and the chief ray height CRH for each optical surface.

The table or tables are designated by the same numbers as the respective figures. A table with additional designation "A" specifies the corresponding aspheric or other relevant data. The aspheric surfaces are calculated according to the following specification:

$$p(h)=[((1/r)h^2)/(1+SQRT(1-(1+K)(1/r)^2h^2))]+C1*h^4+C2*h^6+..$$

In this case, the reciprocal (1/r) of the radius specifies the surface curvature and h specifies the distance between a surface point and the optical axis (i.e. the ray height). Consequently, p(h) specifies the so-called sagitta, that is to say the distance between the surface point and the surface vertex in the z direction (direction of the optical axis). Constant K is the conic constant, and parameter, C1, C2 are aspheric constants.

**Table 3 (k794)**

NA = 0.80; OBH = 66 mm; $\lambda$ = 365 nm $\pm$ 1 nm

| SURF | RADIUS | THICKNESS | MATERIAL | INDEX1 | INDEX2 | INDEX3 | SEMI-DIAM. | \|MRH\| | \|MRH\|/max(\|MRH\|) | CRH |
|---|---|---|---|---|---|---|---|---|---|---|
| 0 | 0,000000 | 18,016080 | L710 | 0,999982 | 0,999982 | 0,999982 | 66,0 | 0,00 | 0,00 | 66,00 |
| 1 | 138,328017 | 27,736324 | FK5HL | 1,503985 | 1,504137 | 1,503835 | 74,2 | 3,69 | 0,05 | 66,00 |
| 2 | 704,718770 | 21,880356 | HE22 | 0,999756 | 0,999756 | 0,999756 | 73,3 | 7,15 | 0,10 | 63,56 |
| 3 | 151,472044 | 17,813459 | FK5HL | 1,503985 | 1,504137 | 1,503835 | 70,6 | 11,50 | 0,15 | 56,91 |
| 4 | 247,159538 | 76,376953 | HE22 | 0,999756 | 0,999756 | 0,999756 | 68,4 | 13,30 | 0,18 | 53,39 |
| 5 | 94,924972 | 9,997648 | FK5HL | 1,503985 | 1,504137 | 1,503835 | 52,9 | 27,99 | 0,37 | 29,89 |
| 6 | 68,567809 | 13,835393 | HE22 | 0,999756 | 0,999756 | 0,999756 | 48,3 | 28,14 | 0,38 | 26,54 |
| 7 | 120,026558 | 43,646540 | FK5HL | 1,503985 | 1,504137 | 1,503835 | 48,0 | 31,39 | 0,42 | 23,62 |
| 8 | -147,768739 | 37,658067 | HE22 | 0,999756 | 0,999756 | 0,999756 | 43,1 | 34,16 | 0,46 | 13,61 |
| 9 | 153,038105 | 27,932702 | FK5HL | 1,503985 | 1,504137 | 1,503835 | 38,1 | 34,08 | 0,46 | -3,63 |
| 10 | -95,025506 | 5,656454 | HE22 | 0,999756 | 0,999756 | 0,999756 | 40,1 | 32,67 | 0,44 | -11,09 |
| 11 | -81,274065 | 9,998754 | LF5HL | 1,619223 | 1,619613 | 1,618836 | 40,0 | 30,88 | 0,41 | -12,98 |
| 12 | 311,582239 | 3,556317 | HE22 | 0,999756 | 0,999756 | 0,999756 | 44,7 | 30,42 | 0,41 | -16,19 |
| 13 | 296,590283 | 27,416395 | FK5HL | 1,503985 | 1,504137 | 1,503835 | 46,6 | 30,48 | 0,41 | -18,17 |
| 14 | -93,234729 | 21,718852 | HE22 | 0,999756 | 0,999756 | 0,999756 | 48,7 | 30,03 | 0,40 | -25,31 |
| 15 | -70,516124 | 9,999150 | LF5HL | 1,619223 | 1,619613 | 1,618836 | 49,2 | 25,27 | 0,34 | -31,02 |
| 16 | 540,359043 | 5,509556 | HE22 | 0,999756 | 0,999756 | 0,999756 | 61,1 | 25,60 | 0,34 | -38,09 |
| 17 | 1059,390644 | 37,419501 | FK5HL | 1,503985 | 1,504137 | 1,503835 | 64,3 | 25,94 | 0,35 | -42,13 |
| 18 | -105,127448 | 0,999737 | HE22 | 0,999756 | 0,999756 | 0,999756 | 68,6 | 27,10 | 0,36 | -52,12 |
| 19 | 383,535950 | 26,072367 | FK5HL | 1,503985 | 1,504137 | 1,503835 | 76,9 | 26,64 | 0,36 | -59,46 |
| 20 | -369,795311 | 258,016706 | HE22 | 0,999756 | 0,999756 | 0,999756 | 77,8 | 24,72 | 0,33 | -62,37 |
| 21 | -194,917064 | -218,017397 | REFL | 0,999756 | 0,999756 | 0,999756 | 125,0 | 15,14 | 0,20 | -105,67 |
| 22 | 176,044470 | 258,016658 | REFL | 0,999756 | 0,999756 | 0,999756 | 98,8 | 14,68 | 0,20 | 88,53 |
| 23 | 384,220376 | 30,949262 | FK5HL | 1,503985 | 1,504137 | 1,503835 | 89,6 | 29,36 | 0,39 | 63,37 |
| 24 | -387,584758 | 1,046250 | HE22 | 0,999756 | 0,999756 | 0,999756 | 89,0 | 31,81 | 0,43 | 60,75 |
| 25 | 122,429340 | 24,323279 | FK5HL | 1,503985 | 1,504137 | 1,503835 | 80,6 | 32,40 | 0,43 | 55,37 |
| 26 | 191,967616 | 68,613801 | HE22 | 0,999756 | 0,999756 | 0,999756 | 76,5 | 31,62 | 0,42 | 49,17 |
| 27 | -174,960535 | 10,001863 | LF5HL | 1,619223 | 1,619613 | 1,618836 | 60,2 | 33,64 | 0,45 | 24,91 |
| 28 | 111,831038 | 24,583132 | HE22 | 0,999756 | 0,999756 | 0,999756 | 57,7 | 35,43 | 0,47 | 22,47 |
| 29 | -384,500051 | 34,660071 | FK5HL | 1,503985 | 1,504137 | 1,503835 | 58,9 | 42,26 | 0,57 | 19,11 |
| 30 | -197,937575 | 0,999793 | HE22 | 0,999756 | 0,999756 | 0,999756 | 65,8 | 51,47 | 0,69 | 16,20 |
| 31 | -341,800258 | 31,694413 | FK5HL | 1,503985 | 1,504137 | 1,503835 | 67,0 | 52,67 | 0,71 | 15,98 |

NA = 0.80; OBH = 66 mm; λ = 365 nm ± 1 nm

| SURF | RADIUS | THICKNESS | MATERIAL | INDEX1 | INDEX2 | INDEX3 | SEMI-DIAM. | \|MRH\| | \|MRH\|/max(\|MRH\|) | CRH |
|---|---|---|---|---|---|---|---|---|---|---|
| 32 | -195,273597 | 0,999713 | HE22 | 0,999756 | 0,999756 | 0,999756 | 71,9 | 59,69 | 0,80 | 12,92 |
| 33 | 544,223516 | 9,999287 | FK5HL | 1,503985 | 1,504137 | 1,503835 | 73,9 | 63,03 | 0,84 | 12,64 |
| 34 | 149,935215 | 8,461764 | HE22 | 0,999756 | 0,999756 | 0,999756 | 74,4 | 65,54 | 0,88 | 11,32 |
| 35 | 166,424790 | 42,075394 | FK5HL | 1,503985 | 1,504137 | 1,503835 | 76,1 | 69,08 | 0,93 | 10,04 |
| 36 | -193,245465 | 24,428619 | HE22 | 0,999756 | 0,999756 | 0,999756 | 77,1 | 71,77 | 0,96 | 4,93 |
| 37 | 0,000000 | -23,429645 | HE22 | 0,999756 | 0,999756 | 0,999756 | 74,6 | 74,63 | 1,00 | 0,04 |
| 38 | 155,948222 | 42,981159 | FK5HL | 1,503985 | 1,504137 | 1,503835 | 74,9 | 74,28 | 1,00 | 4,71 |
| 39 | -199,927947 | 4,539221 | HE22 | 0,999756 | 0,999756 | 0,999756 | 73,1 | 72,94 | 0,98 | -1,38 |
| 40 | -188,429754 | 9,998854 | LF5HL | 1,619223 | 1,619613 | 1,618836 | 71,8 | 70,84 | 0,95 | -2,34 |
| 41 | 135,618945 | 9,004635 | HE22 | 0,999756 | 0,999756 | 0,999756 | 71,5 | 67,34 | 0,90 | -3,69 |
| 42 | 165,295930 | 42,876112 | FK5HL | 1,503985 | 1,504137 | 1,503835 | 73,4 | 68,40 | 0,92 | -5,86 |
| 43 | -167,958764 | 0,999010 | HE22 | 0,999756 | 0,999756 | 0,999756 | 74,7 | 68,67 | 0,92 | -11,96 |
| 44 | 181,442942 | 28,907070 | FK5HL | 1,503985 | 1,504137 | 1,503835 | 72,7 | 62,96 | 0,84 | -12,29 |
| 45 | -679,766256 | 4,201057 | HE22 | 0,999756 | 0,999756 | 0,999756 | 70,9 | 58,98 | 0,79 | -15,00 |
| 46 | 77,948245 | 31,955502 | FK5HL | 1,503985 | 1,504137 | 1,503835 | 58,9 | 47,87 | 0,64 | -15,80 |
| 47 | 263,050277 | 2,618854 | HE22 | 0,999756 | 0,999756 | 0,999756 | 53,2 | 37,58 | 0,50 | -16,34 |
| 48 | 148,392720 | 18,126294 | FK5HL | 1,503985 | 1,504137 | 1,503835 | 48,4 | 33,87 | 0,45 | -16,51 |
| 49 | 197781,389690 | 1,997943 | HE22 | 0,999756 | 0,999756 | 0,999756 | 42,1 | 24,95 | 0,33 | -16,51 |
| 50 | 0,000000 | 10,000000 | FK5HL | 1,503985 | 1,504137 | 1,503835 | 39,3 | 22,28 | 0,30 | -16,51 |
| 51 | 0,000000 | 12,000000 | L710 | 0,999982 | 0,999982 | 0,999982 | 33,0 | 16,00 | 0,21 | -16,50 |
| 52 | 0,000000 | 0,000000 | | | | | 16,5 | 0,00 | 0,00 | -16,50 |

**Table 3A**

Aspheric constants

| SRF | 13 | 21 | 22 | 34 | 35 |
|---|---|---|---|---|---|
| K | 0 | -1,003350 | 0,864754 | 0 | 0 |
| C1 | -5,819184E-08 | -8,057425E-09 | -3,457250E-08 | 1,252979E-08 | -8,764679E-08 |
| C2 | 2,107818E-11 | -5,903834E-15 | -1,219095E-12 | 7,864880E-12 | 6,620762E-12 |
| C3 | 1,265615E-14 | 2,623125E-18 | 6,338016E-17 | -8,139655E-16 | -3,884435E-16 |
| C4 | -2,137381E-17 | -1,937482E-22 | 1,101497E-21 | -2,398799E-19 | -2,357953E-19 |
| C5 | 2,112519E-20 | 2,272160E-26 | -4,368830E-25 | 8,417892E-23 | 8,811456E-23 |
| C6 | -1,167817E-23 | -1,220573E-30 | 4,955034E-30 | -1,579810E-26 | -1,713586E-26 |
| C7 | 3,404638E-27 | 3,758549E-35 | 1,177679E-33 | 1,656436E-30 | 1,790611E-30 |
| C8 | -4,064696E-31 | -4,443239E-40 | -1,149188E-37 | -7,506967E-35 | -8,084067E-35 |

| SRF | 42 | 47 |
|---|---|---|
| K | 0 | 0 |
| C1 | -7,410862E-08 | -1,665656E-07 |
| C2 | -9,406582E-13 | 3,790420E-11 |
| C3 | 7,764390E-16 | 2,641766E-15 |
| C4 | -1,676596E-19 | -2,596982E-18 |
| C5 | 6,094014E-23 | 1,416340E-21 |
| C6 | -1,261822E-26 | -6,026837E-25 |
| C7 | 1,361649E-30 | 1,483905E-28 |
| C8 | -5,782509E-35- | -1,493529E-32 |

**Table 4 (k799)**

NA = 0.80; OBH = 66 mm; λ = 365 nm ± **1** nm

| SURF | RADIUS | THICKNESS | MATERIAL | INDEX1 | INDEX2 | INDEX3 | SEMI-DIAM. | MRH | \|MRH\|/max(\|MRH\|) | CRH |
|---|---|---|---|---|---|---|---|---|---|---|
| 0 | 0,000000 | 16,283396 | L710 | 0,999982 | 0,999982 | 0,999982 | 66,0 | 0,00 | 0,00 | 66,00 |
| 1 | 127,219237 | 32,703242 | FK5HL | 1,503985 | 1,504137 | 1,503835 | 74,3 | 3,33 | 0,04 | 66,00 |
| 2 | 2171,671022 | 3,983764 | HE22 | 0,999756 | 0,999756 | 0,999756 | 73,1 | 7,42 | 0,10 | 63,03 |
| 3 | 213,778679 | 13,754393 | LLF1HL | 1,579208 | 1,579521 | 1,578897 | 70,9 | 8,21 | 0,11 | 59,73 |
| 4 | 286,695306 | 66,543990 | HE22 | 0,999756 | 0,999756 | 0,999756 | 68,6 | 9,66 | 0,13 | 56,61 |
| 5 | 95,211038 | 9,999903 | SIO2HL | 1,474564 | 1,474711 | 1,474418 | 52,9 | 22,72 | 0,30 | 33,86 |
| 6 | 67,611681 | 13,697336 | HE22 | 0,999756 | 0,999756 | 0,999756 | 48,0 | 23,22 | 0,31 | 30,05 |
| 7 | 115,272899 | 67,006073 | FK5HL | 1,503985 | 1,504137 | 1,503835 | 47,7 | 26,48 | 0,36 | 27,20 |
| 8 | -131,674067 | 24,999967 | HE22 | 0,999756 | 0,999756 | 0,999756 | 38,1 | 31,47 | 0,42 | 9,93 |
| 9 | 136,604507 | 21,373373 | FK5HL | 1,503985 | 1,504137 | 1,503835 | 35,2 | 31,52 | 0,42 | -2,42 |
| 10 | -103,450632 | 5,134653 | HE22 | 0,999756 | 0,999756 | 0,999756 | 36,8 | 30,50 | 0,41 | -8,64 |
| 11 | -90,670065 | 9,999385 | LF5HL | 1,619223 | 1,619613 | 1,618836 | 37,0 | 29,03 | 0,39 | -10,67 |
| 12 | 173,225773 | 3,597203 | HE22 | 0,999756 | 0,999756 | 0,999756 | 41,7 | 28,38 | 0,38 | -13,97 |
| 13 | 172,288953 | 26,629443 | FK5HL | 1,503985 | 1,504137 | 1,503835 | 43,9 | 28,53 | 0,38 | -16,25 |
| 14 | -101,903477 | 8,256071 | HE22 | 0,999756 | 0,999756 | 0,999756 | 46,3 | 27,99 | 0,38 | -23,69 |
| 15 | -78,755155 | 9,999123 | LF5HL | 1,619223 | 1,619613 | 1,618836 | 46,8 | 26,54 | 0,36 | -26,11 |
| 16 | 461,387541 | 5,724843 | HE22 | 0,999756 | 0,999756 | 0,999756 | 56,4 | 26,91 | 0,36 | -31,71 |
| 17 | 331,758593 | 36,975614 | FK5HL | 1,503985 | 1,504137 | 1,503835 | 62,6 | 27,37 | 0,37 | -36,70 |
| 18 | -114,040999 | 0,999757 | HE22 | 0,999756 | 0,999756 | 0,999756 | 66,0 | 28,09 | 0,38 | -46,20 |
| 19 | 239,662065 | 20,400783 | FK5HL | 1,503985 | 1,504137 | 1,503835 | 71,7 | 27,51 | 0,37 | -51,89 |
| 20 | -1654,573400 | 261,374380 | HE22 | 0,999756 | 0,999756 | 0,999756 | 71,7 | 25,59 | 0,34 | -53,89 |
| 21 | -187,385183 | -216,651152 | REFL | 0,999756 | 0,999756 | 0,999756 | 124,1 | 16,38 | 0,22 | -104,58 |
| 22 | 176,097719 | 257,024135 | REFL | 0,999756 | 0,999756 | 0,999756 | 100,4 | 13,11 | 0,18 | 89,59 |
| 23 | 875,923577 | 26,901498 | LLF1HL | 1,579208 | 1,579521 | 1,578897 | 90,5 | 29,40 | 0,39 | 64,68 |
| 24 | -340,228671 | 0,999986 | HE22 | 0,999756 | 0,999756 | 0,999756 | 90,4 | 31,68 | 0,43 | 62,93 |
| 25 | 109,602063 | 39,538932 | SIO2HL | 1,474564 | 1,474711 | 1,474418 | 81,3 | 32,34 | 0,43 | 56,76 |
| 26 | 454,027765 | 23,608703 | HE22 | 0,999756 | 0,999756 | 0,999756 | 77,0 | 30,93 | 0,42 | 47,03 |
| 27 | -563,608125 | 9,999284 | LLF1HL | 1,579208 | 1,579521 | 1,578897 | 69,5 | 30,37 | 0,41 | 36,60 |
| 28 | 126,847911 | 28,171316 | HE22 | 0,999756 | 0,999756 | 0,999756 | 61,2 | 30,43 | 0,41 | 32,34 |
| 29 | -222,150110 | 9,999772 | LF5HL | 1,619223 | 1,619613 | 1,618836 | 60,7 | 33,79 | 0,45 | 25,94 |
| 30 | 146,258540 | 15,728097 | HE22 | 0,999756 | 0,999756 | 0,999756 | 61,6 | 36,43 | 0,49 | 24,27 |
| 31 | 1064,408726 | 76,660989 | FK5HL | 1,503985 | 1,504137 | 1,503835 | 63,2 | 42,03 | 0,56 | 22,94 |

NA = 0.80; OBH = 66 mm; λ = 365 nm ± **1** nm

| SURF | RADIUS | THICKNESS | MATERIAL | INDEX1 | INDEX2 | INDEX3 | SEMI-DIAM. | MRH | \|MRH\|/max(\|MRH\|) | CRH |
|---|---|---|---|---|---|---|---|---|---|---|
| 32 | -243,086051 | 0,999990 | HE22 | 0,999756 | 0,999756 | 0,999756 | 77,4 | 60,98 | 0,82 | 17,60 |
| 33 | 491,224417 | 27,173404 | FK5HL | 1,503985 | 1,504137 | 1,503835 | 81,0 | 64,74 | 0,87 | 17,32 |
| 34 | -323,750270 | 9,086675 | HE22 | 0,999756 | 0,999756 | 0,999756 | 81,6 | 66,94 | 0,90 | 14,47 |
| 35 | 299,862889 | 9,998690 | SIO2HL | 1,474564 | 1,474711 | 1,474418 | 80,3 | 69,42 | 0,93 | 12,66 |
| 36 | 122,387011 | 15,406146 | HE22 | 0,999756 | 0,999756 | 0,999756 | 77,1 | 69,22 | 0,93 | 11,23 |
| 37 | 180,108072 | 35,086506 | FK5HL | 1,503985 | 1,504137 | 1,503835 | 78,4 | 72,61 | 0,97 | 8,78 |
| 38 | -404,852946 | 22,834140 | HE22 | 0,999756 | 0,999756 | 0,999756 | 78,3 | 73,69 | 0,99 | 4,46 |
| 39 | 0,000000 | -21,834429 | HE22 | 0,999756 | 0,999756 | 0,999756 | 74,5 | 74,49 | 1,00 | 0,02 |
| 40 | 147,650107 | 40,622767 | FK5HL | 1,503985 | 1,504137 | 1,503835 | 74,7 | 74,44 | 1,00 | 4,25 |
| 41 | -264,964391 | 8,276700 | HE22 | 0,999756 | 0,999756 | 0,999756 | 73,3 | 72,67 | 0,98 | -1,33 |
| 42 | -189,641017 | 9,999358 | LF5HL | 1,619223 | 1,619613 | 1,618836 | 72,0 | 70,42 | 0,95 | -3,04 |
| 43 | 138,517937 | 6,770111 | HE22 | 0,999756 | 0,999756 | 0,999756 | 71,8 | 66,97 | 0,90 | -4,38 |
| 44 | 147,774148 | 49,042218 | FK5HL | 1,503985 | 1,504137 | 1,503835 | 73,7 | 67,91 | 0,91 | -6,01 |
| 45 | -171,715176 | 1,006958 | HE22 | 0,999756 | 0,999756 | 0,999756 | 75,1 | 67,80 | 0,91 | -12,89 |
| 46 | 156,908174 | 28,749390 | FK5HL | 1,503985. | 1,504137 | 1,503835 | 71,7 | 61,14 | 0,82 | -13,26 |
| 47 | -1726,230059 | 1,004749 | HE22 | 0,999756 | 0,999756 | 0,999756 | 69,4 | 56,48 | 0,76 | -15,70 |
| 48 | 77,238269 | 33,469657 | FK5HL | 1,503985 | 1,504137 | 1,503835 | 58,3 | 47,29 | 0,63 | -16,05 |
| 49 | 420,685748 | 2,342240 | HE22 | 0,999756 | 0,999756 | 0,999756 | 52,3 | 36,22 | 0,49 | -16,40 |
| 50 | 239,092895 | 14,985914 | FK5HL | 1,503985 | 1,504137 | 1,503835 | 48,3 | 32,93 | 0,44 | -16,50 |
| 51 | -17916,285152 | 1,994648 | HE22 | 0,999756 | 0,999756 | 0,999756 | 42,0 | 24,97 | 0,34 | -16,50 |
| 52 | 0,000000 | 10,000000 | FK5HL | 1,503985 | 1,504137 | 1,503835 | 39,2 | 22,28 | 0,30 | -16,50 |
| 53 | 0,000000 | 12,000000 | L710 | 0,999982 | 0,999982 | 0,999982 | 32,9 | 16,00 | 0,21 | -16,50 |
| 54 | 0,000000 | 0,000000 | HE22 | 0,999756 | 0,999756 | 0,999756 | 16,5 | 0,00 | 0,00 | -16,50 |

**Table 4A**

Aspheric constants

| SRF | 13 | 20 | 21 | 22 | 37 |
|---|---|---|---|---|---|
| K | 0 | 0 | -1,426910 | 0,768321 | 0 |
| C1 | -8,950568E-08 | 7,451989E-08 | -1,851306E-08 | -3,261156E-08 | -1,654408E-08 |
| C2 | 2,145031E-11 | 5,775401E-13 | 2,950493E-14 | -1,127978E-12 | -1,556314E-13 |
| C3 | -6,543428E-16 | 1,260334E-16 | -1,521314E-18 | -3,874436E-17 | 6,249228E-17 |
| C4 | -8,080608E-18 | -3,710923E-20 | 4,948418E-22 | -2,609898E-21 | 3,963137E-22 |
| C5 | 1,047478E-20 | 8,925988E-24 | -4,735111E-26 | 1,002754E-25 | 1,433527E-24 |
| C6 | -6,644910E-24 | -1,907952E-28 | 3,141554E-30 | -2,502831 E-29 | -1,416262E-28 |
| C7 | 2,160119E-27 | -1,527395E-31 | -1,090206E-34 | 1,644749E-33 | 8,478713E-33 |
| C8 | -2,836726E-31 | 1,700463E-35 | 1,646004E-39 | -7,844568E-38 | 5,460380E-37 |
| SRF | 44 | | | | 49 |
| K | 0 | | | | 0 |
| C1 | -9,340018E-08 | | | | -1,370363E-07 |
| C2 | -2,278372E-13 | | | | 5,365297E-11 |
| C3 | 4,405714E-16 | | | | -3,031115E-15 |
| C4 | 9,186921E-21 | | | | -2,049172E-18 |
| C5 | -3,510115E-26 | | | | 1,365533E-21 |
| C6 | -5,949543E-28 | | | | -4,947647E-25 |
| C7 | 1,066288E-31 | | | | 1,037651E-28 |
| C8 | -5,159260E-36 | | | | -9,308029E-33 |

**Claims**

1.  A catadioptric objective comprising:

    a plurality of optical elements arranged along a single straight optical axis to image a pattern from an off-axis object field in an object surface of the objective to an off-axis image field arranged in an image surface region of the objective at an image-side numerical aperture NA with electromagnetic radiation from a wavelength band around a central wavelength $\lambda$, the optical elements including at least one concave mirror and a plurality of lenses; wherein the plurality of lenses include lenses made from different materials having different Abbe numbers defining a median Abbe number, wherein at least one of the plurality of lenses is a first lens made from a first material having a first Abbe number equal to or greater than the median Abbe number and at least one of the plurality of lenses is made from a second material having an Abbe number smaller than the median Abbe number; wherein
    the lenses include at least two negative lenses of the second material,

at least one of the negative lenses is a first negative lens arranged in a region where a marginal ray height is less than 70% of a maximum marginal ray height in the objective, and
at least one of the negative lenses is a second negative lens arranged in a region where a marginal ray height is at least 70% of a maximum marginal ray height in the objective.

2. Objective according to claim 1, wherein a first negative lens is arranged between two adjacent lenses, where each of the two adjacent lenses has an optically free diameter substantially larger than the optically free diameter of the negative lens.

3. Objective according to claim 1 or 2, wherein a first negative lens has an optically free diameter which is less than 80% of an optically free diameter of a largest lens of the objective.

4. Objective according to one of the preceding claims, wherein the objective includes at least one waist region where a beam diameter of a radiation beam passing through the objective has a local minimum and at least one first negative lens is positioned in the waist region.

5. Objective according to one of the preceding claims, wherein the objective comprises at least two first negative lenses of the second material.

6. Objective according to one of the preceding claims, wherein at least one second negative lens is arranged in a region where the marginal ray height is more than 85% of the maximum marginal ray height, wherein preferably the second negative lens is arranged in a region of the objective where a chief ray height is less than a marginal ray height.

7. Objective according to one of the preceding claims, wherein a second negative lens is combined with at least one positive lens made of the first material and arranged directly adjacent to the second negative lens to form a lens doublet, wherein preferably the lens doublet is arranged in a region of the projection objective where a chief ray height is less than half the marginal ray height in the objective.

8. Objective according to one of the preceding claims, wherein the objective includes:

a first objective part configured to image the pattern into a first intermediate image;
a second objective part configured to image the first intermediate image into a second intermediate image; and
a third objective part configured to image the second intermediate image onto the image surface,
wherein preferably a first concave mirror having a first continuous mirror surface and at least one second concave mirror having a second continuous mirror surface are arranged in the second objective part;
pupil surfaces are formed between the object surface and the first intermediate image, between the first and the second intermediate image and between the second intermediate image and the image surface; and
all concave mirrors are arranged such that the chief ray height at the concave mirrors is larger than the marginal ray height.

9. Objective according to claim 8, wherein at least one of the following conditions is fulfilled:

(i) the objective has exactly two intermediate images;
(ii) the objective includes an even number of concave mirrors;
(iii) the second objective part includes exactly two concave mirrors;
(iv) the first objective part is a refractive objective part;
(v) the third objective part is a refractive objective part;

10. Objective according to one of the preceding claims, wherein the projection objective forms an image of the pattern in a respective Petzval surface for each wavelength $\lambda$ of a wavelength band, the Petzval surfaces deviating from each other for different wavelengths;
wherein a longitudinal departure p of the Petzval surface at a given wavelength from a planar reference surface at an edge field point of the image field (at maximum image height y'), measured parallel to the optical axis in the image surface region, varies with the wavelength $\lambda$ according to

$$dp/d\lambda < (k\,\lambda/NA^2)\,/\,nm,$$

wherein k=1.0, wherein preferably k=0.5 and/or k= 0.2.

11. A catadioptric objective comprising:

a plurality of optical elements arranged along a single straight optical axis to image a pattern from an off-axis object field in an object surface of the objective to an off-axis image field in an image surface region of the objective at an image-side numerical-aperture NA with-electromagnetic radiation from a wavelength band around a central wavelength $\lambda$, the optical elements including a concave mirror and a plurality of lenses;

wherein the projection objective forms an image of the pattern in a respective Petzval surface for each wavelength $\lambda$ of a wavelength band, the Petzval surfaces deviating from each other for different wavelengths;

wherein a longitudinal departure p of the Petzval surface at a given wavelength from a planar reference surface at an edge field point of the image field (at maximum image height y') , measured parallel to the optical axis in the image surface region, varies with the wavelength $\lambda$ according to

$$dp/d\lambda < (k\ \lambda/NA^2)\ /\ nm,$$

wherein k=1.0

12. Objective according to claim 11, wherein k=0.5, wherein preferably k= 0.2.

13. Objective according to claim 11 or 12, wherein at least one of the following conditions is fulfilled:

(i) the objective has an image-side numerical aperture NA $\geq$ 0.5.
(ii) the objective has an image-side numerical aperture NA $\geq$ 0.6 and the wavelength difference is 5nm or less;
(iii) the central wavelength $\lambda$ is greater than 300 nm and $dp/d\lambda < (\lambda/NA^2)/nm$.

14. Projection exposure apparatus configured to expose a radiation-sensitive substrate arranged in a region of an image surface of a projection objective with at least one image of a pattern of a mask that is arranged in a region of an object surface of the projection objective, comprising:

a radiation source emitting ultraviolet radiation from a wavelength band around a central operating wavelength $\lambda$;
an illumination system receiving the radiation from the radiation source and shaping illumination radiation directed onto the pattern of the mask; and
the projection objective according to one of the preceding claims.

15. Projection exposure apparatus according to claim 14, wherein $\lambda$ > 300 nm and wherein the wavelength band includes a first wavelength $\lambda_1 < \lambda$ and a second wavelength $\lambda_2 > \lambda$ separated from the first wavelength by a wavelength difference $\Delta\lambda = \lambda_2 - \lambda_1$ greater than 1 nm.

Fig. 1

S →  ⊗

ILL

I

$\lambda_0 - \Delta\lambda/2 \quad \lambda_0 \quad \lambda_0 + \Delta\lambda/2$

$\lambda [nm]$

PO

L1

L2

PS2

PS1

PS3

IF

P

$\frac{\lambda}{NA^2}$

Y'

OA

Fig. 2A

_Fig._ 2 B

_Fig._ 2C

Fig 3A

Fig 3B

Fig 3C

Fig 3D

Fig. 4A

Obj Height 66 mm
0.0005 mm

Obj Height 46.7 mm
0.0005 mm

AXIS
0.0005 mm

Fig. 4D

ASTIGMATISM
S × T + (mm)

-0.001    0.001

Fig. 4C

CHROMATIC
FOCAL SHIFT (mm)

0.366

0.365

-0.0001    0.0001

Fig. 4B

Fig. 4

EP 2 196 838 A1

**EUROPEAN SEARCH REPORT**

Application Number

EP 08 02 1519

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/195423 A1 (KAMENOV VLADIMIR [DE] ET AL KAMENOW VLADIMIR [DE] ET AL) 23 August 2007 (2007-08-23) * figure 2; table 2 * | 1-9,14, 15 | INV. G02B17/08 G03F7/20 |

TECHNICAL FIELDS SEARCHED (IPC)

G02B
G03F

~~The present search report has been drawn up for all claims~~

| Place of search | Date of completion of the search | Examiner |
|---|---|---|
| Munich | 12 March 2009 | Michel, Alain |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt
European
Patent Office
Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-9, 14, 15

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 08 02 1519

The Search Division considers that the present European patent application does not comply with the
requirements of unity of invention and relates to several inventions or groups of inventions, namely:

1. claims: 1-9,14,15

   Claim 1 relates to a catadioptric objective arranged along a
   single straight optical axis. Claims 2-9, 14 and 15 depend
   on claim 1.
   The underlying problem to be solved is how to better correct
   chromatic aberrations.
   The special feature is the two materials the lenses are
   composed of, a lower dispersion and a higher dispersion one,
   two negative lenses being made of the higher dispersion
   material (lower Abbe number).
   ---

2. claims: 10-13

   Independent claim 11 relates to a catadioptric objective
   arranged along a single straight optical axis. Claims 12 and
   13 depend on claim 11. Claim 10 related to the same problem.
   The underlying problem to be solved is how to image
   curvature.
   The special feature is the Petzval surface onto which an
   image is formed, the longitudinal departure of which meeting
   an inequality.
   ---

## ANNEX TO THE EUROPEAN SEARCH REPORT
## ON EUROPEAN PATENT APPLICATION NO.

EP 08 02 1519

This annex lists the patent family members relating to the patent documents cited in the above-mentioned European search report.
The members are as contained in the European Patent Office EDP file on
The European Patent Office is in no way liable for these particulars which are merely given for the purpose of information.

12-03-2009

| Patent document cited in search report | Publication date | Patent family member(s) | Publication date |
|---|---|---|---|
| US 2007195423 A1 | 23-08-2007 | NONE | |

EPO FORM P0459

For more details about this annex : see Official Journal of the European Patent Office, No. 12/82

**EP 2 196 838 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1855160 A2
- US 11747630 B
- US 620978 A
- US 4469414 A
- US 20050190435 A1